(19) Europäisches Patentamt / European Patent Office / Office européen des brevets

(11) **EP 4 079 515 A1**

(12) **EUROPEAN PATENT APPLICATION**
published in accordance with Art. 153(4) EPC

(43) Date of publication:
26.10.2022 Bulletin 2022/43

(21) Application number: 20900892.9

(22) Date of filing: 30.11.2020

(51) International Patent Classification (IPC):
*B32B 27/00* (2006.01)     *B32B 27/18* (2006.01)
*B32B 27/30* (2006.01)     *C09J 5/00* (2006.01)
*C09J 201/00* (2006.01)    *H01L 21/301* (2006.01)
*C09J 7/29* (2018.01)      *C09J 7/38* (2018.01)

(52) Cooperative Patent Classification (CPC):
B32B 27/00; B32B 27/18; B32B 27/30; C09J 5/00;
C09J 7/29; C09J 7/38; C09J 201/00; H01L 21/30

(86) International application number:
PCT/JP2020/044513

(87) International publication number:
WO 2021/124856 (24.06.2021 Gazette 2021/25)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 20.12.2019  JP 2019230602
01.07.2020  JP 2020114047

(71) Applicant: **Nitto Denko Corporation**
**Ibaraki-shi, Osaka 567-8680 (JP)**

(72) Inventors:
• **UENO, Shusaku**
**Ibaraki-shi, Osaka 567-8680 (JP)**
• **HIRAYAMA, Takamasa**
**Ibaraki-shi, Osaka 567-8680 (JP)**

(74) Representative: **Müller-Boré & Partner**
**Patentanwälte PartG mbB**
**Friedenheimer Brücke 21**
**80639 München (DE)**

(54) **ADHESIVE SHEET**

(57) Provided is a pressure-sensitive adhesive sheet capable of allowing a small electronic part (e.g., a chip having a size of 100 $\mu m\square$ or less) to be temporarily fixed in a satisfactory manner and satisfactorily peeled. The pressure-sensitive adhesive sheet of the present invention includes: a gas-generating layer; and a gas barrier layer arranged on at least one side of the gas-generating layer, wherein the gas barrier layer is a layer that is deformed through laser light irradiation of the pressure-sensitive adhesive sheet, wherein a thickness ($\mu$m) of a high-ly elastic portion of the gas barrier layer is equal to or smaller than a value calculated by the following expression (1), and wherein the thickness ($\mu$m) of the highly elastic portion of the gas barrier layer is equal to or larger than a value calculated by the following expression (2) :
$12546 \times EXP(-0.728 \times \log_{10}(Er \times 10^6))$ ... (1) ;
$18096 \times EXP(-0.949 \times \log_{10}(Er \times 10^6))$ ... (2), where Er represents a modulus of elasticity (MPa) of the highly elastic portion of the gas barrier layer by a nanoindentation method at 25°C.

Fig.1

EP 4 079 515 A1

## Description

Technical Field

The present invention relates to a pressure-sensitive adhesive sheet.

Background Art

Hitherto, in processing of an electronic part, an operation involving temporarily fixing a workpiece onto a pressure-sensitive adhesive sheet during processing, and peeling the workpiece from the pressure-sensitive adhesive sheet after processing has been performed in some cases. As the pressure-sensitive adhesive sheet to be used in such operation, there is sometimes used a pressure-sensitive adhesive sheet having a predetermined pressure-sensitive adhesive strength during processing, and being capable of having its pressure-sensitive adhesive strength decreased after processing. As one such pressure-sensitive adhesive sheet, there is a proposal of a pressure-sensitive adhesive sheet having a configuration in which its pressure-sensitive adhesive layer contains thermally expandable microspheres (for example, Patent Literature 1). The pressure-sensitive adhesive sheet containing the thermally expandable microspheres has the following feature: while the sheet has a predetermined pressure-sensitive adhesive strength, the pressure-sensitive adhesive strength is decreased or eliminated by expanding the thermally expandable microspheres through heating to form unevenness on its pressure-sensitive adhesive surface, resulting in a reduced contact area. Such pressure-sensitive adhesive sheet has an advantage in that the workpiece can be easily peeled therefrom without an external stress.

However, in recent years, along with tendencies of various devices to be lightweighted and mounted in increasing numbers, downsizing of an electronic part has been advanced, resulting in a need to temporarily fix an electronic part downsized to a size comparable to those of the thermally expandable microspheres. When the electronic part whose downsizing has been advanced is temporarily fixed and processed, influences of, for example, a site where a thermally expandable microsphere having a large particle diameter due to a variation in particle diameter is present, and a site where no thermally expandable microsphere is present are increased, and hence satisfactory peeling cannot be performed at those sites in some cases.

Citation List

Patent Literature

[PTL 1] JP 2001-131507 A

Summary of Invention

Technical Problem

The present invention has been made to solve the problem of the related art described above, and an object of the present invention is to provide a pressure-sensitive adhesive sheet capable of allowing a small electronic part (e.g., a chip having a size of 100 $\mu$m/$\square$ or less) to be temporarily fixed in a satisfactory manner and satisfactorily peeled.

Solution to Problem

According to one aspect of the present invention, there is provided a pressure-sensitive adhesive sheet, including: a gas-generating layer; and a gas barrier layer arranged on at least one side of the gas-generating layer, wherein the gas barrier layer is a layer having a surface that is deformed through laser light irradiation of the pressure-sensitive adhesive sheet, wherein a thickness ($\mu$m) of a highly elastic portion of the gas barrier layer is equal to or smaller than a value calculated by the following expression (1), and wherein the thickness ($\mu$m) of the highly elastic portion of the gas barrier layer is equal to or larger than a value calculated by the following expression (2):

$$35011 \times EXP(-0.812 \times \log_{10}(Er \times 10^6)) \quad \cdots \quad (1)$$

$$20081 \times EXP(-1.145 \times \log_{10}(Er \times 10^6)) \quad \cdots \quad (2)$$

where Er represents a modulus of elasticity (MPa) of the highly elastic portion of the gas barrier layer by a nanoindentation method at 25°C.

In one embodiment, the gas-generating layer is a layer capable of absorbing UV light.

In one embodiment, the gas-generating layer contains a UV absorber.

In one embodiment, the gas barrier layer includes a pressure-sensitive adhesive layer.

In one embodiment, the gas barrier layer further includes an intermediate layer.

In one embodiment, the modulus of elasticity of the highly elastic portion of the gas barrier layer by the nanoindentation method is from 0.01 MPa to 10 GPa.

In one embodiment, the gas barrier layer has a thickness of from 0.1 $\mu$m to 200 $\mu$m.

In one embodiment, a deformation amount of the surface of the gas barrier layer caused by laser light irradiation of the gas barrier layer is 0.6 $\mu$m or more in terms of vertical displacement of the gas barrier layer.

In one embodiment, the pressure-sensitive adhesive sheet has a piercing strength of from 10 mN to 5,000 mN.

In one embodiment, an elongation of the pressure-sensitive adhesive sheet in a normal direction is 0.1 mm or more.

In one embodiment, the intermediate layer contains a thermoplastic resin.

In one embodiment, the intermediate layer is a resin film formed from a styrene-based elastomer.

In one embodiment, the intermediate layer contains a curable resin.

In one embodiment, the curable resin is a UV-curable resin.

According to another aspect of the present invention, there is provided a method of treating an electronic part. The method of treating an electronic part includes: bonding an electronic part onto the pressure-sensitive adhesive sheet; and peeling the electronic part from the pressure-sensitive adhesive sheet by irradiating the pressure-sensitive adhesive sheet with laser light.

In one embodiment, the peeling the electronic part is performed in a position-selective manner.

In one embodiment, the method of treating an electronic part further includes subjecting the electronic part to a predetermined treatment after the bonding the electronic part onto the pressure-sensitive adhesive sheet and before the peeling the electronic part from the pressure-sensitive adhesive sheet.

In one embodiment, the treatment is grinding processing, dicing processing, die bonding, wire bonding, etching, vapor deposition, molding, circuit formation, inspection, a product check, cleaning, transfer, arrangement, repair, or protection of a device surface.

In one embodiment, the method of treating an electronic part further includes placing the electronic part on another sheet after the peeling the electronic part from the pressure-sensitive adhesive sheet.

Advantageous Effects of Invention

According to the present invention, it is possible to provide the pressure-sensitive adhesive sheet capable of allowing a small electronic part (e.g., a chip having a size of 100 $\mu$m□ or less) to be temporarily fixed in a satisfactory manner, the pressure-sensitive adhesive sheet being capable of allowing the small electronic part to be satisfactorily peeled by virtue of including the gas-generating layer capable of generating a gas through laser light irradiation.

Brief Description of Drawings

FIG. 1 is a schematic sectional view of a pressure-sensitive adhesive sheet according to one embodiment of the present invention.

FIG. 2 is a schematic sectional view of a pressure-sensitive adhesive sheet according to another embodiment of the present invention.

FIG. 3 is a schematic view for illustrating a method of measuring a piercing strength and an elongation in a normal direction.

Description of Embodiments

A. Outline of Pressure-sensitive Adhesive Sheet

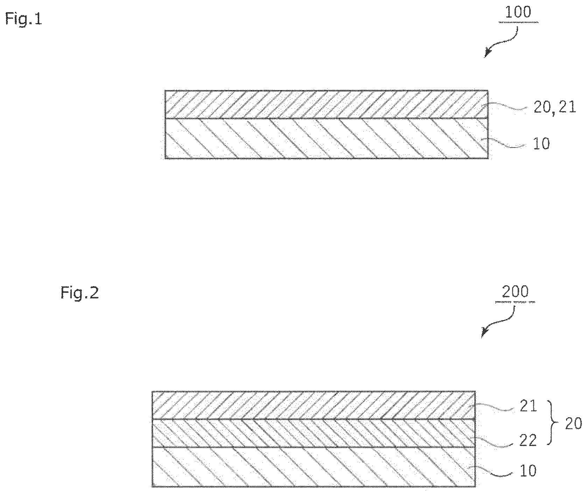

FIG. **1** is a schematic sectional view of a pressure-sensitive adhesive sheet according to a preferred embodiment of the present invention. A pressure-sensitive adhesive sheet **100** includes a gas-generating layer **10** and a gas barrier layer **20** arranged on at least one surface of the gas-generating layer **10**. The gas-generating layer **10** generates a gas through laser light irradiation. More specifically, the gas-generating layer **10** is a layer that generates a gas through the gasification of a component thereof by laser light irradiation. UV laser light is typically used as the laser light. The gas barrier layer **20** is capable of having its surface deformed by irradiating the pressure-sensitive adhesive sheet (substantially the gas-generating layer) with laser light. In one embodiment, the deformation may be caused by the gas generated from the gas-generating layer 10 to occur on the opposite side of the gas barrier layer **20** to the gas-generating layer **10**. UV laser light is typically used as the laser light.

In one embodiment, the gas barrier layer **20** includes a pressure-sensitive adhesive layer **21**. The pressure-sensitive adhesive layer **21** may be typically arranged on the outermost side of the pressure-sensitive adhesive sheet **100**.

The pressure-sensitive adhesive sheet of the present invention may be used by bonding a workpiece such as an electronic part to the pressure-sensitive adhesive layer. The pressure-sensitive adhesive sheet of the present invention includes the gas-generating layer, and partly generates a gas in a fine range through laser light irradiation. The gas generation causes the pressure-sensitive adhesive layer to deform, and as a result, peelability is expressed in the portion irradiated with laser light. The laser light is typically radiated from the opposite side of the gas-generating layer to the pressure-sensitive adhesive layer. In the present invention, the gas barrier layer is arranged as described above, and hence an unnecessary escape of the gas generated from the gas-generating layer is prevented, with the result that the pressure-sensitive adhesive layer is satisfactorily deformed through laser light irradiation. According to the present invention, the deformation can be caused in a fine range as described above, and hence, even in the processing of a small electronic part that is extremely fine, the small electronic part can be satisfactorily peeled. In addition, even when a small electronic part that needs to be peeled and a small electronic part that does not need to be peeled are temporarily fixed so as to be adjacent to each other, it is possible to perform peeling at the site to be peeled and prevent peeling at the site not to be peeled. That is, only the small electronic part that needs to be peeled can be peeled, and unnecessary separation of a small electronic part can be prevented. In addition, the pressure-sensitive adhesive sheet is excellent in directivity at the time of peeling and peelable only at a desired site, and hence has an advantage in that breakage is prevented and an adhesive residue is reduced as well. The directivity at the time of peeling is an indicator showing positional accuracy when an adherend such as a small electronic part is to be peeled from the pressure-sensitive adhesive sheet and ejected toward a place at a certain distance. When the directivity is excellent, the adherend is prevented from flying in an unexpected direction at the time of peeling.

The deformation of the gas barrier layer means a displacement occurring in a direction horizontal with respect to the normal direction (thickness direction) of the gas barrier layer (direction orthogonal to the thickness direction). The deformation of the gas barrier layer is caused by, for example, performing a pulse scan with UV laser light having a wavelength of 355 nm and a beam diameter of about 20 $\mu$m$\varphi$ at an output of 0.80 mW and a frequency of 40 kHz to generate a gas from the gas-generating layer. A shape after the deformation is observed, for example, from measurement with a confocal laser microscope, a noncontact interference microscope (WYKO), or the like on any appropriate one spot subjected to the pulse scan after 1 minute from the laser light irradiation. The shape may be foaming (protrusion), a through-hole (unevenness), or a recess (depression), and any such deformation may generate peelability. In order to efficiently peel an electronic part in the normal direction, a change in displacement in the normal direction between before and after the laser light irradiation is preferably large, and such a change as to form a foaming shape is particularly suitable. With regard to the foaming (protrusion), its highest point and full width at half maximum with reference to an unirradiated portion of the surface of the pressure-sensitive adhesive sheet are defined as a vertical displacement Y and a horizontal displacement X (diameter), respectively. With regard to the through-hole (unevenness) and the recess (depression) each forming a hole after the laser light irradiation, the difference between the highest point and the lowest point is defined as the vertical displacement Y, and the diameter of the hole is defined as the horizontal displacement X. A portion deformed through laser light irradiation is hereinafter sometimes referred to as "deformed portion". The vertical displacement of the gas barrier layer is preferably 0.6 $\mu$m or more, more preferably 0.7 $\mu$m or more, still more preferably 1.0 $\mu$m or more. When the vertical displacement falls within such ranges, the peelability is excellent, and the directivity at the time of peeling is excellent. In addition, peeling can be accurately performed in a desired direction, and as a result, an adhesive residue, breakage, and the like can be prevented. The upper limit of the vertical displacement is, for example, 10 $\mu$m (preferably 20 $\mu$m). The horizontal displacement of the gas barrier layer is preferably 60 $\mu$m or less, more preferably 50 $\mu$m or less, still more preferably 40 $\mu$m or less. When the horizontal displacement falls within such ranges, a small adherend can be preferably peeled only at a desired site. In addition, even when adherends are arranged at a small interval, a similar effect can be expected. The lower limit of the horizontal displacement is, for example, 3 $\mu$m (preferably 4 $\mu$m).

FIG. **2** is a schematic sectional view of a pressure-sensitive adhesive sheet according to another embodiment of the present invention. In a pressure-sensitive adhesive sheet **200,** the gas barrier layer **20** further includes an intermediate layer **22**. The pressure-sensitive adhesive sheet **200** includes the pressure-sensitive adhesive layer **21,** the intermediate layer **22,** and the gas-generating layer **10** in the stated order. When the intermediate layer is arranged, the shape of the deformed portion can be easily controlled. In addition, when the intermediate layer is arranged, a pressure-sensitive adhesive sheet improved in gas barrier property and capable of forming a deformed portion in a more preferred manner can be obtained. The intermediate layer may be a single layer, or may be a multilayer.

The pressure-sensitive adhesive sheet may further include another layer (not shown). For example, a base material, another pressure-sensitive adhesive layer, or the like may be arranged on the surface of the gas-generating layer on the opposite side to the gas barrier layer. For example, a film formed from any appropriate resin is used as the base material.

In the pressure-sensitive adhesive sheet of the present invention, a thickness ($\mu$m) of a highly elastic portion of the gas barrier layer is equal to or smaller than a value calculated by the following expression (1), and the thickness ($\mu$m) of the highly elastic portion of the gas barrier layer is equal to or larger than a value calculated by the following expression (2):

$$35011 \times EXP(-0.812 \times \log_{10}(Er \times 10^6)) \quad \cdots \quad (1)$$

$$20081 \times EXP(-1.145 \times \log_{10}(Er \times 10^6)) \quad \cdots \quad (2)$$

where Er represents a modulus of elasticity (MPa) of the highly elastic portion of the gas barrier layer by a nanoindentation method.

It is more preferred that the thickness ($\mu$m) of the highly elastic portion of the gas barrier layer is equal to or smaller than a value calculated by the following expression (3), and the thickness ($\mu$m) of the highly elastic portion of the gas barrier layer is equal to or larger than a value calculated by the following expression (4):

$$20023 \times EXP(-0.761 \times \log_{10}(Er \times 10^6)) \quad \cdots \quad (3)$$

$$18923 \times EXP(-1.028 \times \log_{10}(Er \times 10^6)) \quad \cdots \quad (4).$$

It is still more preferred that the thickness ($\mu$m) of the highly elastic portion of the gas barrier layer is equal to or smaller than a value calculated by the following expression (5), and the thickness ($\mu$m) of the highly elastic portion of the gas barrier layer is equal to or larger than a value calculated by the following expression (6):

$$12546 \times EXP(-0.728 \times \log_{10}(Er \times 10^6)) \quad \cdots \quad (5)$$

$$18096 \times EXP(-0.949 \times \log_{10}(Er \times 10^6)) \quad \cdots \quad (6).$$

When the gas barrier layer has a single-layer configuration (e.g., when the gas barrier layer is formed of a single layer that is the pressure-sensitive adhesive layer), the term "highly elastic portion of the gas barrier layer" as used herein means the gas barrier layer itself (the pressure-sensitive adhesive layer when the gas barrier layer is formed of a single layer that is the pressure-sensitive adhesive layer), and when the gas barrier layer has a multilayer configuration (e.g., when the gas barrier layer is formed of the pressure-sensitive adhesive layer and the intermediate layer), the term means the layer having the highest modulus of elasticity. In one embodiment, when the gas barrier layer includes the intermediate layer and the pressure-sensitive adhesive layer, the "thickness of the highly elastic portion of the gas barrier layer" may correspond to the thickness of the intermediate layer, and the "modulus of elasticity of the highly elastic portion of the gas barrier layer by the nanoindenter method at 25°C" may correspond to such modulus of elasticity of the intermediate layer.

The modulus of elasticity by the nanoindentation method is obtained by: perpendicularly pressing a Berkovich (triangular pyramid-shaped) probe made of diamond against a sectional surface cut out of a layer serving as a measurement object; and subjecting the thus obtained displacement-load hysteresis curve to numerical processing with software (TriboScan) included with a measurement apparatus. As used herein, the term "modulus of elasticity" refers to a modulus of elasticity measured with a nanoindenter (Triboindenter TI-950 manufactured by Hysitron, Inc.) by a single indentation method at a predetermined temperature (25°C) under the measurement conditions of an indentation speed of about 500 nm/sec, a drawing speed of about 500 nm/sec, and an indentation depth of about 1,500 nm. Herein, when the modulus of elasticity by the nanoindentation method is simply referred to without mentioning a sectional surface or a surface, the modulus of elasticity means the modulus of elasticity of the sectional surface by the nanoindentation method.

In the present invention, the thickness ($\mu$m) of the highly elastic portion of the gas barrier layer is equal to or smaller than the value calculated by the expression (1), and hence there can be provided a pressure-sensitive adhesive sheet that is excellent in peelability because its gas barrier layer sufficiently deforms. In addition, the thickness ($\mu$m) of the highly elastic portion of the gas barrier layer is equal to or larger than the value calculated by the expression (2), and hence there can be provided a pressure-sensitive adhesive sheet that hardly causes a failure such as rupture because excessive deformation of its gas barrier layer is prevented. That is, in the present invention, by virtue of the configuration in which the upper limit and lower limit of the thickness ($\mu$m) of the highly elastic portion of the gas barrier layer satisfy the expressions (1) and (2), deformation occurs in a preferred manner through gas generation, the rupture or the like of the deformed portion hardly occurs, and even in the processing of a small electronic part, the small electronic part can be peeled satisfactorily (that is, with good peelability, in a selective manner, and with an adhesive residue being prevented).

The pressure-sensitive adhesive strength of the pressure-sensitive adhesive layer of the pressure-sensitive adhesive sheet of the present invention with respect to SUS430 is preferably 0.1 N/20 mm or more, more preferably from 0.2 N/20 mm to 50 N/20 mm, still more preferably from 0.5 N/20 mm to 40 N/20 mm, particularly preferably from 0.7 N/20 mm to 20 N/20 mm, most preferably from 1 N/20 mm to 10 N/20 mm. When the pressure-sensitive adhesive strength falls within such ranges, for example, a pressure-sensitive adhesive sheet showing a pressure-sensitive adhesive property satisfactory as a temporary fixing sheet to be used in the production of an electronic part can be obtained. As used herein, the term "pressure-sensitive adhesive strength" refers to a pressure-sensitive adhesive strength measured under an environment at 23°C by a method in conformity with JIS Z 0237:2000 (bonding conditions: one pass back and forth with a 2 kg roller, tensile rate: 300 mm/min, peel angle: 180°).

In one embodiment, the gas-generating layer has a predetermined pressure-sensitive adhesive strength. The pressure-sensitive adhesive strength of the gas-generating layer of the pressure-sensitive adhesive sheet of the present invention with respect to SUS430 is preferably 0.1 N/20 mm or more, more preferably from 0.5 N/20 mm to 50 N/20 mm, still more preferably from 1 N/20 mm to 40 N/20 mm, particularly preferably from 1.5 N/20 mm to 30 N/20 mm, most preferably from 2 N/20 mm to 20 N/20 mm. When the pressure-sensitive adhesive strength falls within such ranges, for example, a pressure-sensitive adhesive sheet showing a pressure-sensitive adhesive property satisfactory as a temporary fixing sheet to be used in the production of an electronic part can be obtained.

The thickness of the pressure-sensitive adhesive sheet of the present invention is preferably from 2 $\mu$m to 200 $\mu$m, more preferably from 3 $\mu$m to 150 $\mu$m, still more preferably from 5 $\mu$m to 120 $\mu$m.

The water vapor transmission rate of the pressure-sensitive adhesive sheet of the present invention is preferably 5,000 $g/(m^2 \cdot day)$ or less, more preferably 4,800 $g/(m^2 \cdot day)$ or less, still more preferably 4,500 $g/(m^2 \cdot day)$ or less, still more preferably 4,200 $g/(m^2 \cdot day)$ or less. In the pressure-sensitive adhesive sheet having a water vapor transmission rate in such ranges, the escape of the gas generated through laser light irradiation is prevented, and hence a deformed portion of an excellent shape is formed in the gas barrier layer. When such pressure-sensitive adhesive sheet is used, a small adherend (e.g., electronic part) can be accurately peeled. The water vapor transmission rate of the pressure-sensitive adhesive sheet of the present invention is preferably as small as possible, but its lower limit value is, for example, 0.1 $g/(m^2 \cdot day)$. The water vapor transmission rate may be measured under an atmosphere at 30°C and 90%RH by a measurement method in conformity with JIS K7129B.

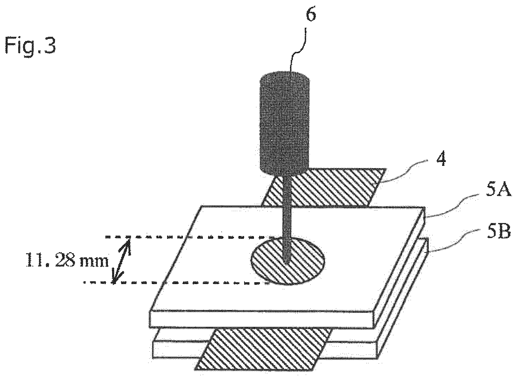

The piercing strength of the pressure-sensitive adhesive sheet of the present invention is preferably from 10 mN to 5,000 mN, more preferably from 30 mN to 4,000 mN, still more preferably from 50 mN to 3,000 mN, particularly preferably from 100 mN to 2,000 mN. When the piercing strength falls within such ranges, a pressure-sensitive adhesive sheet that deforms in a preferred manner through gas generation and hardly causes the rupture and the like of a deformed portion can be obtained. When such pressure-sensitive adhesive sheet is used, a small adherend (e.g. , electronic part) can be accurately peeled. As illustrated in FIG. **3,** the piercing strength is measured by sandwiching a sample **4** (e.g., the pressure-sensitive adhesive sheet) between sample holders **5A** and **5B** having a circular opening with a diameter of 11.28 mm through use of a compression testing machine **6** (manufactured by Kato Tech Co., Ltd., product name: "KES-G5"). More specifically, a piercing needle (radius of curvature: 1 mm) is caused to pierce the sample (piercing speed: 0.1 mm/s) at the center of the circular opening under a measurement temperature of 23°C, and the maximum load at the breaking point may be defined as the piercing strength. The piercing strength of the pressure-sensitive adhesive sheet may be a characteristic dependent on the mechanical characteristics of the gas barrier layer.

The elongation of the pressure-sensitive adhesive sheet in a normal direction is preferably 0.1 mm or more, more preferably 0.5 mm or more, still more preferably 0.8 mm or more. When the elongation falls within such ranges, a protrusion having a small diameter can be formed in the surface of the barrier layer. When such pressure-sensitive adhesive sheet is used, a small adherend (e.g., electronic part) can be accurately peeled. The upper limit of the elongation of the pressure-sensitive adhesive sheet in the normal direction is, for example, 50 mm. The elongation in the normal direction corresponds to the distance by which the piercing needle is pushed at the breaking point in the measurement of the piercing strength, and means the elongation of the sample (e.g., the pressure-sensitive adhesive sheet) in its plane direction.

The haze value of the pressure-sensitive adhesive sheet of the present invention is preferably 50% or less, more preferably from 0.1% to 40%, still more preferably from 0.2% to 30%. When the haze value falls within such ranges, an adherend (e.g., a table for temporarily fixing an electronic part) is visible through the pressure-sensitive adhesive sheet, and hence, for example, a pressure-sensitive adhesive sheet excellent in visibility of a marking provided on the fixing table for indicating the temporary fixing position of an electronic part can be obtained. The pressure-sensitive adhesive sheet of the present invention can have a configuration in which each layer included in the pressure-sensitive adhesive sheet is free of an insoluble filler, and hence a pressure-sensitive adhesive sheet having a small haze value and being excellent in adherend visibility as described above can be obtained. Such effect is an excellent effect that cannot be obtained with a pressure-sensitive adhesive sheet containing an insoluble filler (e.g., thermally expandable microspheres).

The UV light transmittance of the pressure-sensitive adhesive sheet at a wavelength of 360 nm is preferably 30% or less, more preferably 20% or less, still more preferably 15% or less, particularly preferably 10% or less, most preferably 5% or less. The lower limit of the UV light transmittance of the pressure-sensitive adhesive sheet at a wavelength of 360 nm is, for example, 0% (preferably 0.05%, more preferably 0.1%).

The 10% weight loss temperature of the pressure-sensitive adhesive sheet is preferably from 200°C to 500°C, more preferably from 220°C to 450°C, still more preferably from 250°C to 400°C, particularly preferably from 270°C to 370°C. When the 10% weight loss temperature falls within such ranges, a pressure-sensitive adhesive sheet capable of forming a more satisfactory deformed portion through laser light irradiation can be obtained. The 10% weight loss temperature of the pressure-sensitive adhesive sheet means a temperature at the time point when the weight of the pressure-sensitive adhesive sheet in TGA analysis at the time of an increase in temperature of the pressure-sensitive adhesive sheet reduces by 10 wt% as compared to the weight thereof before the temperature increase (that is, the weight of the pressure-sensitive adhesive sheet becomes 90% as compared to the weight thereof before irradiation).

## B. Gas-generating Layer

The gas-generating layer may be a layer capable of absorbing UV light. In one embodiment, the gas-generating layer contains a UV absorber. When the UV absorber is incorporated, a gas-generating layer capable of absorbing laser light to gasify can be formed. The gas-generating layer typically contains the UV absorber and a pressure-sensitive adhesive A. The UV absorber preferably exists dissolved in the pressure-sensitive adhesive A. When the UV absorber exists dissolved in the pressure-sensitive adhesive A, a pressure-sensitive adhesive sheet that can generate a deformed portion (e.g., an uneven portion) at any site of its gas barrier layer and has little variation among the shapes of deformed portions (e.g., uneven portions) can be obtained. When such pressure-sensitive adhesive sheet is used, a deformed portion (e.g., uneven portion) can be accurately generated at a desired site, and hence the effect of the present invention becomes remarkable. Herein, the state of "existing dissolved in the pressure-sensitive adhesive" means that the UV absorber does not exist as particles in the gas-generating layer. More specifically, the gas-generating layer is preferably free of a UV absorber having a particle diameter of 10 $\mu$m or more in the measurement of a particle distribution in a sectional surface of the gas-generating layer by X-ray CT. The gas-generating layer may or may not contain a component insoluble in the pressure-sensitive adhesive. In one embodiment, the presence or absence and content of the insoluble component in the gas-generating layer are estimated on the basis of the haze value of the gas-generating layer, and as the haze value becomes lower, the content of the insoluble component in the gas-generating layer is estimated to be smaller. It is preferred that the gas-generating layer be substantially free of the component insoluble in the pressure-sensitive adhesive.

The modulus of elasticity of the gas-generating layer (sectional surface of the gas-generating layer) by the nanoindentation method is preferably from 0.01 MPa to 1,000 MPa, more preferably from 0.05 MPa to 800 MPa. When the modulus of elasticity falls within such ranges, a change in shape of the gas-generating layer caused by gas generation occurs in a preferred manner, and as a result, a deformed portion of an excellent shape is formed in the gas barrier layer. The modulus of elasticity of the gas-generating layer may be adjusted on the basis of, for example, the kind of a material contained in the layer of interest, the structure of a base polymer forming the material, and the kind and amount of an additive added to the layer of interest.

The modulus of elasticity of the surface of the gas-generating layer by the nanoindentation method is preferably from 0.01 MPa to 1,000 MPa, more preferably from 0.05 MPa to 800 MPa. When the modulus of elasticity falls within such ranges, a change in shape of the gas-generating layer caused by gas generation occurs in a preferred manner, and as a result, a deformed portion of an excellent shape is formed in the gas barrier layer. The modulus of elasticity by the nanoindentation method refers to a modulus of elasticity determined from an applied load-indentation depth curve obtained by continuously measuring, during loading and unloading, an applied load to an indenter and an indentation depth when the indenter is pushed into a sample (e.g., a pressure-sensitive adhesive surface). The modulus of elasticity by the nanoindentation method is obtained by: perpendicularly pressing a Berkovich (triangular pyramid-shaped) probe made of diamond; and subjecting the thus obtained displacement-load hysteresis curve to numerical processing with software (TriboScan) included with a measurement apparatus. As used herein, the term "modulus of elasticity of the surface by the nanoindentation method" refers to a modulus of elasticity measured with a nanoindenter (Triboindenter TI-950 manufactured by Hysitron, Inc.) by a single indentation method at a predetermined temperature (25°C) under the measurement conditions of an indentation speed of about 500 nm/sec, a drawing speed of about 500 nm/sec, and an indentation depth of about 3,000 nm. The modulus of elasticity of the gas-generating layer may be adjusted on the basis of, for example, the kind of a material contained in the layer of interest, the structure of a base polymer forming the material, and the kind and amount of an additive added to the layer of interest. In the present invention, a modulus of elasticity by the nanoindentation method measured by the above-mentioned method using a sectional surface as a measurement surface and a modulus of elasticity by the nanoindentation method measured by the above-mentioned method using a surface as a measurement surface do not significantly differ from each other, and hence, when it is difficult to perform measurement from the sectional surface, a value measured from the surface may be adopted as a value measured from the sectional surface.

The gasification starting temperature of the gas-generating layer is preferably from 150°C to 500°C, more preferably from 170°C to 450°C, still more preferably from 190°C to 420°C, particularly preferably from 200°C to 400°C. When the gasification starting temperature falls within such ranges, a pressure-sensitive adhesive sheet capable of forming a more satisfactory deformed portion through laser light irradiation can be obtained. Herein, the gasification starting temperature of the gas-generating layer means a gas generation rise-up temperature calculated from EGA analysis at the time of an increase in temperature of the pressure-sensitive adhesive sheet. The gas generation rise-up temperature is defined as a temperature at which the half value of the highest gas generation peak of an EGA/MS spectrum obtained from EGA analysis is reached. As the gasification starting temperature becomes lower, the temperature at which a gas starts to be generated at the time of laser light irradiation becomes lower, and hence a sufficient amount of the gas is generated even when the laser light irradiation is performed with a smaller output. In one embodiment, the gasification starting temperature of the gas-generating layer corresponds to the gasification starting temperature of the UV absorber.

The 10% weight loss temperature of the gas-generating layer is preferably from 150°C to 500°C, more preferably from 170°C to 450°C, still more preferably from 200°C to 400°C. When the 10% weight loss temperature falls within such ranges, a pressure-sensitive adhesive sheet capable of forming a more satisfactory deformed portion through laser light irradiation can be obtained. The 10% weight loss temperature of the gas-generating layer means a temperature at the time point when the weight of the gas-generating layer in TGA analysis at the time of an increase in temperature of the pressure-sensitive adhesive sheet (e.g., at the time of an increase in temperature thereof through laser light irradiation) reduces by 10 wt% as compared to the weight thereof before the temperature increase (that is, the weight of the gas-generating layer becomes 90% as compared to the weight thereof before the temperature increase).

The thickness of the gas-generating layer is preferably from 0.1 $\mu$m to 50 $\mu$m, more preferably from 1 $\mu$m to 40 $\mu$m, still more preferably from 2 $\mu$m to 30 $\mu$m, particularly preferably from 5 $\mu$m to 20 $\mu$m. When the thickness falls within such ranges, a pressure-sensitive adhesive sheet capable of forming a more satisfactory deformed portion through laser light irradiation can be obtained.

The modulus of elasticity Er(gas) [unit: MPa] of the gas-generating layer by the nanoindentation method and the thickness h(gas) [unit: $\mu$m] thereof satisfy the following expression (i).

$$\mathrm{Log}(\mathrm{Er}(\mathrm{gas}) \times 10^6) \geqq 8.01 \times \mathrm{h}(\mathrm{gas})^{-0.116} \cdots (\mathrm{i})$$

In the present invention, the gas-generating layer is configured to satisfy the expression (1), and hence excessive deformation by the gas generated from the gas-generating layer is prevented, and the pressure-sensitive adhesive sheet is satisfactorily deformed through laser light irradiation. When such gas-generating layer is formed, surface deformation in a fine range can be caused without arranging a thick barrier layer as a layer for preventing excessive deformation, and hence the gas barrier layer can be flexibly configured.

In one embodiment, the modulus of elasticity Er(gas) [unit: MPa] by the nanoindentation method and the thickness h(gas) [unit: $\mu$m] satisfy the following expression (ii). In one embodiment, the modulus of elasticity Er(gas) [unit: MPa] by the nanoindentation method and the thickness h(gas) [unit: $\mu$m] satisfy the following expression (iii).

$$\mathrm{Log}(\mathrm{Er}(\mathrm{gas}) \times 10^6) \geqq 7.66 \times \mathrm{h}(\mathrm{gas})^{-0.092} \cdots (\mathrm{ii})$$

$$\mathrm{Log}(\mathrm{Er}(\mathrm{gas}) \times 10^6) \geqq 7.52 \times \mathrm{h}(\mathrm{gas})^{-0.081} \cdots (\mathrm{iii})$$

When the modulus of elasticity and the thickness fall within such ranges, the above-mentioned effect becomes more remarkable.

In one embodiment, the modulus of elasticity Er(gas) [unit: MPa] by the nanoindentation method and the thickness h(gas) [unit: μm] further satisfy the following expression (iv) .

$$\mathrm{Log}(\mathrm{Er}(\mathrm{gas}) \times 10^6) \leqq 47.675 \times \mathrm{h}(\mathrm{gas})^{-0.519} \quad \cdots \quad (\mathrm{iv})$$

The UV light transmittance of the gas-generating layer at a wavelength of 360 nm is preferably 30% or less, more preferably 20% or less, still more preferably 15% or less, particularly preferably 10% or less, most preferably 5% or less. The lower limit of the UV light transmittance of the gas-generating layer at a wavelength of 360 nm is, for example, 0% (preferably 0.05%, more preferably 0.1%).

The haze value of the gas-generating layer is preferably 55% or less, more preferably from 0.1% to 50%, still more preferably from 0.5% to 40%.

B-1. UV Absorber

Any appropriate UV absorber may be used as the UV absorber as long as the effect of the present invention is obtained. Examples of the UV absorber include a benzotriazole-based UV absorber, a benzophenone-based UV absorber, a triazine-based UV absorber, a salicylate-based UV absorber, and a cyanoacrylate-based UV absorber. Of those, a triazine-based UV absorber or a benzotriazole-based UV absorber is preferred, and a triazine-based UV absorber is particularly preferred. In particular, when an acrylic pressure-sensitive adhesive is used as the pressure-sensitive adhesive A, the triazine-based UV absorber may be preferably used because of its high compatibility with the base polymer of the acrylic pressure-sensitive adhesive. The triazine-based UV absorber more preferably includes a compound having a hydroxy group, and is particularly preferably a UV absorber (hydroxyphenyltriazine-based UV absorber) including a hydroxyphenyltriazine-based compound.

Examples of the hydroxyphenyltriazine-based UV absorber include a reaction product of 2-(4,6-bis(2,4-dimethylphenyl)-1,3,5-triazin-2-yl)-5-hydroxyphenyl and a [(C10-C16 (mainly C12-C13) alkyloxy)methyl]oxirane (product name: "TINUVIN 400", manufactured by BASF SE), 2-[4,6-bis(2,4-dimethylphenyl)-1,3,5-triazin-2-yl]-5-[3-(dodecyloxy)-2-hydroxypropoxy]phenol, a reaction product of 2-(2,4-dihydroxyphenyl)-4,6-bis-(2,4-dimethylphenyl)-1,3,5-triazine and (2-ethylhexyl)-glycidic acid ester (product name: "TINUVIN 405", manufactured by BASF SE), 2,4-bis(2-hydroxy-4-butoxyphenyl)-6-(2,4-dibutoxyphenyl)-1,3,5-triazine (product name: "TINUVIN 460", manufactured by BASF SE), 2-(4,6-diphenyl-1,3,5-triazin-2-yl)-5-[(hexyl)oxyl-phenol (product name: "TINUVIN 1577", manufactured by BASF SE), 2-(4,6-diphenyl-1,3,5-triazin-2-yl)-5-[2-(2-ethylhexanoyloxy)ethoxy]-phenol (product name: "ADK STAB LA-46", manufactured by ADEKA Corporation), 2-(2-hydroxy-4-[1-octyloxycarbonylethoxy]phenyl)-4,6-bis(4-phenylphenyl)-1,3,5-triazine (product name: "TINUVIN 479", manufactured by BASF SE), and a product available under the product name "TINUVIN 477" from BASF SE.

Examples of the benzotriazole-based UV absorber (benzotriazole-based compound) include 2-(2-hydroxy-5-tert-butylphenyl)-2H-benzotriazole (product name: "TINUVIN PS", manufactured by BASF SE), an ester compound of benzenepropanoic acid and 3-(2H-benzotriazol-2-yl)-5-(1,1-dimethylethyl)-4-hydroxy (C7-9 side chain and linear alkyl) (product name: "TINUVIN 384-2", manufactured by BASF SE), a mixture of octyl 3-[3-tert-butyl-4-hydroxy-5-(5-chloro-2H-benzotriazol-2-yl)phenyl] propionate and 2-ethylhexyl-3-[3-tert-butyl-4-hydroxy-5-(5-chloro-2H-benzotriazol-2-yl)phenyl] propionate (product name: "TINUVIN 109", manufactured by BASF SE), 2-(2H-benzotriazol-2-yl)-4,6-bis(1-methyl-1-phenylethyl)phenol (product name: "TINUVIN 900", manufactured by BASF SE), 2-(2H-benzotriazol-2-yl)-6-(1-methyl-1-phenylethyl)-4-(1,1,3,3-tetramethylbutyl)phenol (product name: "TINUVIN 928", manufactured by BASF SE), a reaction product of methyl 3-(3-(2H-benzotriazol-2-yl)-5-tert-butyl-4-hydroxyphenyl) propionate/polyethylene glycol 300 (product name: "TINUVIN 1130", manufactured by BASF SE), 2-(2H-benzotriazol-2-yl)-p-cresol (product name: "TINUVIN P", manufactured by BASF SE), 2-(2H-benzotriazol-2-yl)-4,6-bis(1-methyl-1-phenylethyl)phenol (product name: "TINUVIN 234", manufactured by BASF SE), 2-[5-chloro-2H-benzotriazol-2-yl]-4-methyl-6-(tert-butyl)phenol (product name: "TINUVIN 326", manufactured by BASF SE), 2-(2H-benzotriazol-2-yl)-4,6-di-tert-pentylphenol (product name: "TINUVIN 328", manufactured by BASF SE), 2-(2H-benzotriazol-2-yl)-4-(1,1,3,3-tetramethylbutyl)phenol (product name: "TINUVIN 329", manufactured by BASF SE), 2,2'-methylenebis[6-(2H-benzotriazol-2-yl)-4-(1,1,3,3-tetramethylbutyl)phenol] (product name: "TINUVIN 360", manufactured by BASF SE), a reaction product of methyl 3-(3-(2H-benzotriazol-2-yl)-5-tert-butyl-4-hydroxyphenyl) propionate and polyethylene glycol 300 (product name: "TINUVIN 213", manufactured by BASF SE), 2-(2H-benzotriazol-2-yl)-6-dodecyl-4-methylphenol (product name: "TINUVIN 571", manufactured by BASF SE), 2-[2-hydroxy-3-(3,4,5,6-tetrahydrophthalimido-methyl)-5-methylphenyl]benzotriazole (product name: "Sumisorb 250", manufactured by Sumitomo Chemical Co., Ltd.), 2-(3-tert-butyl-2-hydroxy-5-methylphenyl)-5-chloro-2H-benzotriazole (product name: "SEESORB 703", manufactured by Shipro Kasei Kaisha, Ltd.), 2-(2H-benzotriazol-2-yl)-4-methyl-6-(3,4,5,6-tetrahydrophthalimidylmethyl)phenol (product name: "SEESORB 706", manufactured by Shipro Kasei Kaisha, Ltd.), 2-(4-benzoyloxy-2-hydroxyphenyl)-5-chloro-2H-benzotriazole (product name: "SEESORB 7012BA", manufactured by Shipro Kasei Kaisha, Ltd.), 2-tert-butyl-6-(5-chloro-2H-benzotriazol-2-yl)-4-methylphenol (product name: "KEMISORB 73", manufactured by Chemipro Kasei Kaisha, Ltd.), 2,2'-methylenebis[6-(2H-benzotriazol-2-yl)-4-tert-octylphenol] (product name: "ADK STAB LA-31", manufactured by ADEKA Corporation), 2-(2H-benzotriazol-2-yl)-p-cellulose (product name: "ADK STAB LA-32", manufactured by ADEKA Corporation), and 2-(5-chloro-2H-benzotriazol-2-yl)-6-tert-butyl-4-methylphenol (product name: "ADK STAB LA-36", manufactured by ADEKA Corporation).

The molecular weight of the compound for forming the UV absorber is preferably from 200 to 1,500, more preferably from 250 to 1,200, still more preferably from 300 to 1,000. When the molecular weight falls within such ranges, a pressure-sensitive adhesive sheet that can form a more satisfactory deformed portion through laser light irradiation can be obtained.

The maximum absorption wavelength of the UV absorber is preferably from 300 nm to 450 nm, more preferably from 320 nm to 400 nm, still more preferably from 330 nm to 380 nm.

The content ratio of the UV absorber is preferably from 1 part by weight to 100 parts by weight, more preferably from 1 part by weight to 50 parts by weight, still more preferably from 5 parts by weight to 30 parts by weight with respect to 100 parts by weight of the gas-generating layer. When the content ratio falls within such ranges, a pressure-sensitive adhesive sheet capable of forming a more satisfactory deformed portion through laser light irradiation can be obtained.

B-2. Pressure-sensitive Adhesive A

A pressure-sensitive adhesive A having pressure sensitivity is preferably used as the pressure-sensitive adhesive A contained in the gas-generating layer. Examples of the pressure-sensitive adhesive A include an acrylic pressure-sensitive adhesive, a rubber-based pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, and a styrene-diene block copolymer-based pressure-sensitive adhesive. Of those, an acrylic pressure-sensitive adhesive or a rubber-based pressure-sensitive adhesive is preferred, and an acrylic pressure-sensitive adhesive is more preferred. The pressure-sensitive adhesives may be used alone or in combination thereof.

An example of the acrylic pressure-sensitive adhesive is an acrylic pressure-sensitive adhesive containing, as a base polymer, an acrylic polymer (homopolymer or copolymer) using one or two or more kinds of (meth) acrylic acid alkyl esters as a monomer component. Specific examples of the (meth)acrylic acid alkyl ester include (meth)acrylic acid C1-20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic acid alkyl ester having a linear or branched alkyl group having 4 to 18 carbon atoms may be preferably used.

The acrylic polymer may contain a unit corresponding to any other monomer component copolymerizable with the (meth)acrylic acid alkyl ester, as required, for the purpose of modification of cohesive strength, heat resistance, cross-linkability, or the like. Examples of such monomer component include: carboxyl group-containing monomers, such as acrylic acid, methacrylic acid, carboxyethyl acrylate, carboxypentyl acrylate, itaconic acid, maleic acid, fumaric acid, and crotonic acid; acid anhydride monomers, such as maleic anhydride and itaconic anhydride; hydroxyl group-containing monomers, such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate, and (4-hydroxymethylcyclohexyl)methyl methacrylate; sulfonic acid group-containing monomers, such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; (N-substituted) amide-based monomers, such as (meth)acrylamide, N,N-dimethyl(meth)acrylamide, N-butyl(meth)acrylamide, N-methylol (meth)acrylamide, and N-methylolpropane (meth)acrylamide; aminoalkyl (meth)acrylate-based monomers, such as aminoethyl (meth)acrylate, N,N-dimethylaminoethyl (meth)acrylate, and t-butylaminoethyl (meth)acrylate; alkoxyalkyl (meth)acrylate-based monomers, such as methoxyethyl (meth)acrylate and ethoxyethyl (meth)acrylate; maleimide-based monomers, such as N-cyclohexylmaleimide, N-isopropylmaleimide, N-laurylmaleimide, and N-phenylmaleimide; itaconimide-based monomers, such as N-methyl itaconimide, N-ethyl itaconimide, N-butyl itaconimide, N-octyl itaconimide, N-2-ethylhexyl itaconimide, N-cyclohexyl itaconimide, and N-lauryl itaconimide; succinimide-based monomers, such as N-(meth)acryloyloxymethylene succinimide, N-(meth)acryloyl-6-oxyhexamethylene succinimide, and N-(meth)acryloyl-8-oxyoctamethylene succinimide; vinyl-based monomers, such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic acid amides, styrene, $\alpha$-methylstyrene, and N-vinylcaprolactam; cyanoacrylate monomers, such as acrylonitrile and methacrylonitrile; epoxy group-containing acrylic monomers, such as glycidyl (meth)acrylate; glycol-based acrylic ester monomers, such as polyethylene glycol (meth)acrylate, polypropylene glycol (meth)acrylate, methoxyethylene glycol (meth)acrylate, and methoxypolypropylene glycol (meth)acrylate; acrylic acid ester-based monomers each having, for example, a heterocycle, a halogen atom, or a silicon atom, such as tetrahydrofurfuryl (meth)acrylate, fluorine (meth)acrylate, and silicone (meth)acrylate; polyfunctional monomers, such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, and urethane acrylate; olefin-based monomers, such as isoprene, butadiene, and isobutylene; and vinyl ether-based monomers, such as vinyl ether. Those monomer components may be used alone or in combination thereof.

The rubber-based pressure-sensitive adhesive is, for example, a rubber-based pressure-sensitive adhesive including, as a base polymer, a natural rubber, or a synthetic rubber, such as a polyisoprene rubber, a styrene-butadiene (SB) rubber, a styrene-isoprene (SI) rubber, a styrene-isoprene-styrene block copolymer (SIS) rubber, a styrene-butadiene-styrene block copolymer (SBS) rubber, a styrene-ethylene-butylene-styrene block copolymer (SEBS) rubber, a styrene-ethylene-propylene-styrene block copolymer (SEPS) rubber, a styrene-ethylenepropylene block copolymer (SEP) rubber, a reclaimed rubber, a butyl rubber, polyisobutylene, or a modified product thereof.

The gas generated from the gas-generating layer is preferably a hydrocarbon (preferably aliphatic hydrocarbon)-based gas. A gas-generating layer capable of generating a hydrocarbon-based gas is formed using, for example, a hydrocarbon-based compound as a main component. The gas-generating layer is preferably free of a compound containing a halogen element. When the gas to be generated is a hydrocarbon-based gas, the corrosion of an electronic part serving as a workpiece can be prevented. Such effect is made more remarkable by forming a gas-generating layer free of a compound containing a halogen element. The formula weight of an ion generated from the gas-generating layer is preferably from 10 m/z to 800 m/z, more preferably from 11 m/z to 700 m/z, still more preferably from 12 m/z to 500 m/z, particularly preferably from 13 m/z to 400 m/z.

The pressure-sensitive adhesive A may contain any appropriate additive as required. Examples of the additive include a cross-linking agent, a tackifier (e.g., a rosin-based tackifier, a terpene-based tackifier, or a hydrocarbon-based tackifier), a plasticizer (e.g., a trimellitic acid ester-based plasticizer or a pyromellitic acid ester-based plasticizer), a pigment, a dye, an age resistor, a conductive material, an antistatic agent, a light stabilizer, a peeling modifier, a softener, a surfactant, a flame retardant, and an antioxidant.

Examples of the cross-linking agent include an isocyanate-based cross-linking agent, an epoxy-based cross-linking agent, a melamine-based cross-linking agent, a peroxide-based cross-linking agent, a urea-based cross-linking agent, a metal alkoxide-based cross-linking agent, a metal chelate-based cross-linking agent, a metal salt-based cross-linking agent, a carbodiimide-based cross-linking agent, an oxazoline-based cross-linking agent, an aziridine-based cross-linking agent, and an amine-based cross-linking agent. Of those, an isocyanate-based cross-linking agent or an epoxy-based cross-linking agent is preferred.

Specific examples of the isocyanate-based cross-linking agent include: lower aliphatic polyisocyanates, such as butylene diisocyanate and hexamethylene diisocyanate; alicyclic isocyanates, such as cyclopentylene diisocyanate, cyclohexylene diisocyanate, and isophorone diisocyanate; aromatic isocyanates, such as 2,4-tolylene diisocyanate, 4,4'-diphenylmethane diisocyanate, and xylylene diisocyanate; and isocyanate adducts, such as a trimethylolpropane/tolylene diisocyanate trimer adduct (manufactured by Nippon Polyurethane Industry Co., Ltd., product name "Coronate L"), a trimethylolpropane/hexamethylene diisocyanate trimer adduct (manufactured by Nippon Polyurethane Industry Co., Ltd., product name "Coronate HL"), and an isocyanurate form of hexamethylene diisocyanate (manufactured by Nippon Polyurethane Industry Co., Ltd., product name "Coronate HX"). The content of the isocyanate-based cross-linking agent may be set to any appropriate amount depending on the desired pressure-sensitive adhesive strength, and is typically from 0.1 part by weight to 20 parts by weight, more preferably from 0.5 part by weight to 10 parts by weight with respect to 100 parts by weight of the base polymer.

Examples of the epoxy-based cross-linking agent include N,N,N',N'-tetraglycidyl-m-xylenediamine, diglycidylaniline, 1,3-bis(N,N-glycidylaminomethyl)cyclohexane (manufactured by Mitsubishi Gas Chemical Company, Inc., product name "TETRAD-C"), 1,6-hexanediol diglycidyl ether (manufactured by Kyoeisha Chemical Co., Ltd., product name "Epolite 1600"), neopentyl glycol diglycidyl ether (manufactured by Kyoeisha Chemical Co., Ltd., product name "Epolite 1500NP"), ethylene glycol diglycidyl ether (manufactured by Kyoeisha Chemical Co., Ltd., product name "Epolite 40E"), propylene glycol diglycidyl ether (manufactured by Kyoeisha Chemical Co., Ltd., product name "Epolite 70P"), polyethylene glycol diglycidyl ether (manufactured by NOF Corporation, product name "EPIOL E-400"), polypropylene glycol diglycidyl ether (manufactured by NOF Corporation, product name "EPIOL P-200"), sorbitol polyglycidyl ether (manufactured by Nagase ChemteX Corporation, product name "Denacol EX-611"), glycerol polyglycidyl ether (manufactured by Nagase ChemteX Corporation, product name "Denacol EX-314"), pentaerythritol polyglycidyl ether, polyglycerol polyglycidyl ether (manufactured by Nagase ChemteX Corporation, product name "Denacol EX-512"), sorbitan polyglycidyl ether, trimethylolpropane polyglycidyl ether, adipic acid diglycidyl ester, o-phthalic acid diglycidyl ester, triglycidyl-tris(2-hydroxyethyl) isocyanurate, resorcin diglycidyl ether, bisphenol-S-diglycidyl ether, and an epoxy-based resin having two or more epoxy groups in a molecule thereof. The content of the epoxy-based cross-linking agent may be set to any appropriate amount depending on the desired pressure-sensitive adhesive strength, and is typically from 0.01 part by weight to 10 parts by weight, more preferably from 0.03 part by weight to 5 parts by weight with respect to 100 parts by weight of the base polymer.

C. Gas Barrier Layer

The term "gas barrier layer" means a layer having a water vapor transmission rate of 10,000 g /(m$^2$·day) or less. The water vapor transmission rate of the gas barrier layer is preferably 7,000 g/(m$^2$·day) or less, more preferably 5,000 g/(m$^2$·day) or less, still more preferably 4,800 g/(m$^2$·day) or less, particularly preferably 4,500 g/ (m$^2$·day) or less, most preferably 4,200 g/(m$^2$·day) or less. When the water vapor transmission rate falls within such ranges, there can be obtained a pressure-sensitive adhesive sheet that allows a small adherend (e.g., electronic part) to be accurately peeled because a deformed portion of an excellent shape is formed. The water vapor transmission rate of the gas barrier layer is preferably as small as possible, but its lower limit value is, for example, 1 g/ (m$^2$·day).

The piercing strength of the gas barrier layer is preferably from 10 mN to 5,000 mN, more preferably from 30 mN to 4,000 mN, still more preferably from 50 mN to 3,000 mN, particularly preferably from 100 mN to 2,000 mN. When the piercing strength falls within such ranges, the gas barrier layer satisfactorily functions, and besides, a change in shape due to gas generation occurs in a preferred manner, with the result that a deformed portion of an excellent shape is formed in the gas barrier layer (pressure-sensitive adhesive layer). When such pressure-sensitive adhesive sheet is used, a small adherend (e.g., electronic part) can be accurately peeled.

In the present invention, when the piercing strength of the gas barrier layer falls within the above-mentioned ranges, a gas barrier layer excellent in gas barrier property is formed. In addition, a change in shape of the gas barrier layer due to gas generation occurs in a preferred manner, and as a result, a depression of an excellent shape is formed. More specifically, when the piercing strength of the gas barrier layer falls within the above-mentioned ranges, the gas barrier layer is likely to change in shape in its thickness direction at the time of the generation of a gas through irradiation with laser light, and as a result, for example, a protrusion having a small diameter can be formed. When such pressure-sensitive adhesive sheet is used, a small adherend (e.g., electronic part) can be accurately peeled.

The piercing strength of the gas barrier layer per unit thickness is preferably from 2 mN/$\mu$m to 1,200 mN/$\mu$m, more preferably from 3 mN/$\mu$m to 1,000 mN/$\mu$m, still more preferably from 5 mN/$\mu$m to 700 mN/$\mu$m. When the piercing strength of the gas barrier layer per unit thickness falls within such ranges, the gas barrier layer functions, and besides, a change in shape due to gas generation occurs in a preferred manner, with the result that a deformed portion of an excellent shape is formed in the gas barrier layer (pressure-sensitive adhesive layer). When such pressure-sensitive adhesive sheet is used, a small adherend (e.g., electronic part) can be accurately peeled. The "piercing strength of the gas barrier layer per unit thickness" may be determined by dividing the piercing strength (mN) of gas barrier layer by the thickness ($\mu$m) of the gas barrier layer.

The modulus of elasticity of the highly elastic portion of the gas barrier layer by the nanoindentation method is preferably from 0.01 MPa to 10 GPa, more preferably from 0.05 MPa to 10 GPa, still more preferably from 0.1 MPa to 10 GPa, particularly preferably from 0.5 MPa to 9.8 GPa. When the modulus of elasticity falls within such ranges, the gas barrier layer can be made excellent in mechanical characteristics and excellent in gas barrier property. In addition, when high elasticity is achieved within the above-mentioned ranges, the thickness of the gas barrier layer can be reduced.

The thickness of the gas barrier layer is preferably from 0.1 $\mu$m to 200 $\mu$m, more preferably from 0.5 $\mu$m to 150 $\mu$m, still more preferably from 1 $\mu$m to 100 $\mu$m, particularly preferably from 1.5 $\mu$m to 50 $\mu$m. When the thickness falls within such ranges, a gas barrier layer capable of deforming in a preferred manner can be formed.

The UV light transmittance of the gas barrier layer at a wavelength of 360 nm is preferably from 50% to 100%, more preferably from 60% to 95%.

C-1. Pressure-sensitive Adhesive Layer

The pressure-sensitive adhesive layer contains any appropriate pressure-sensitive adhesive B. The pressure-sensitive adhesive B may be a pressure-sensitive adhesive B1 having pressure sensitivity, or may be a curable pressure-sensitive adhesive B2.

The thickness of the pressure-sensitive adhesive layer is preferably from 0.1 $\mu$m to 200 $\mu$m, more preferably from 0.5 $\mu$m to 150 $\mu$m, still more preferably from 1 $\mu$m to 100 $\mu$m, particularly preferably from 2 $\mu$m to 50 $\mu$m. When the thickness falls within such ranges, a pressure-sensitive adhesive layer that has a preferred pressure-sensitive adhesive strength and satisfactorily functions as a gas barrier layer can be formed.

The water vapor transmission rate of the pressure-sensitive adhesive layer is preferably 20,000 g/(m$^2$·day) or

less, more preferably 10,000 g/(m$^2$·day) or less, still more preferably 7,000 g/(m$^2$·day) or less, still more preferably 5,000 g/(m$^2$·day) or less, particularly preferably 4,800 g/(m$^2$·day) or less, most preferably 4,500 g/(m$^2$·day) or less. When the water vapor transmission rate falls within such ranges, the pressure-sensitive adhesive layer satisfactorily functions as a gas barrier layer, and hence a deformed portion of an excellent shape is formed. When such pressure-sensitive adhesive sheet is used, a small adherend (e.g., electronic part) can be accurately peeled. The water vapor transmission rate of the pressure-sensitive adhesive layer is preferably as small as possible, but its lower limit value is, for example, 100 g/(m$^2$·day).

The piercing strength of the pressure-sensitive adhesive layer is preferably from 10 mN to 3,000 mN, more preferably from 30 mN to 2,500 mN, still more preferably from 50 mN to 2,000 mN, particularly preferably from 100 mN to 2,000 mN. When the piercing strength falls within such ranges, the pressure-sensitive adhesive layer satisfactorily functions as a gas barrier layer, and besides, a change in shape due to gas generation occurs in a preferred manner, with the result that a deformed portion of an excellent shape is formed. When such pressure-sensitive adhesive sheet is used, a small adherend (e.g., electronic part) can be accurately peeled.

The UV light transmittance of the pressure-sensitive adhesive layer at a wavelength of 360 nm is preferably from 50% to 100%, more preferably from 60% to 95%.

C-1-1. Pressure-sensitive Adhesive B1 having Pressure Sensitivity

Examples of the pressure-sensitive adhesive B1 having pressure sensitivity include an acrylic pressure-sensitive adhesive, a rubber-based pressure-sensitive adhesive, a vinyl alkyl ether-based pressure-sensitive adhesive, a silicone-based pressure-sensitive adhesive, a polyester-based pressure-sensitive adhesive, a polyamide-based pressure-sensitive adhesive, a urethane-based pressure-sensitive adhesive, and a styrene-diene block copolymer-based pressure-sensitive adhesive. Of those, an acrylic pressure-sensitive adhesive or a rubber-based pressure-sensitive adhesive is preferred, and an acrylic pressure-sensitive adhesive is more preferred. The pressure-sensitive adhesive described in the section B-2 may be used as the pressure-sensitive adhesive B1 contained in the pressure-sensitive adhesive layer containing the pressure-sensitive adhesive having pressure sensitivity.

C-1-2. Curable Pressure-sensitive Adhesive B2

Examples of the curable pressure-sensitive adhesive B2 include a thermosetting pressure-sensitive adhesive and an active energy ray-curable pressure-sensitive adhesive. Of those, an active energy ray-curable pressure-sensitive adhesive is preferably used. The pressure-sensitive adhesive layer formed by the active energy ray-curable pressure-sensitive adhesive is a pressure-sensitive adhesive layer formed through irradiation with an active energy ray, that is, a pressure-sensitive adhesive layer having a predetermined pressure-sensitive adhesive strength after active energy ray irradiation.

As a resin material for forming the active energy ray-curable pressure-sensitive adhesive, there are given, for example, resin materials described in UV Curing System (written by Kiyomi Kato, published by Sogo Gijutsu Center (1989)), Photocuring Technology (edited by Technical Information Institute Co., Ltd. (2000)), JP 2003-292916 A, JP 4151850 B2, and the like. More specific examples thereof include a resin material (B2-1) containing a polymer serving as a parent agent and an active energy ray-reactive compound (monomer or oligomer), and a resin material (B2-2) containing an active energy ray-reactive polymer.

Examples of the polymer serving as a parent agent include: rubber-based polymers, such as a natural rubber, a polyisobutylene rubber, a styrene-butadiene rubber, a styrene-isoprene-styrene block copolymer rubber, a reclaimed rubber, a butyl rubber, a polyisobutylene rubber, and a nitrile rubber (NBR); silicone-based polymers; and acrylic polymers. Those polymers may be used alone or in combination thereof.

The active energy ray-reactive compound is, for example, a photoreactive monomer or oligomer having a plurality of functional groups each having a carbon-carbon multiple bond, such as an acryloyl group, a methacryloyl group, a vinyl group, an allyl group, or an acetylene group. Of those, a compound having an ethylenically unsaturated functional group is preferably used, and a (meth)acrylic compound having an ethylenically unsaturated functional group is more preferably used. The compound having an ethylenically unsaturated functional group easily produces a radical with UV light, and hence, when such compound is used, a pressure-sensitive adhesive layer capable of curing within a short time period can be formed. In addition, when the (meth)acrylic compound having an ethylenically unsaturated functional group is used, a pressure-sensitive adhesive layer having a moderate hardness after curing can be formed. Specific examples of the photoreactive monomer or oligomer include: (meth)acryloyl group-containing compounds, such as trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butanediol di(meth)acrylate, 1,6-hexanediol di(meth)acrylate, polyethylene glycol di(meth)acrylate, and a urethane (meth)acrylate-based compound; and dimers to pentamers of the (meth)acryloyl group-containing compounds.

Those compounds may be used alone or in combination thereof.

In addition, a monomer, such as epoxidized butadiene, glycidyl methacrylate, acrylamide, or vinylsiloxane, or an oligomer formed of the monomer may be used as the active energy ray-reactive compound. The resin material (B2-1) containing any such compound can be cured with a high-energy ray, such as UV light or an electron beam.

Further, a mixture of an organic salt such as an onium salt, and a compound having a plurality of heterocycles in a molecule thereof may be used as the active energy ray-reactive compound. When the mixture is irradiated with an active energy ray (e.g., UV light or an electron beam), the organic salt cleaves to produce an ion, and the ion serves as an initiation species to cause the ring-opening reaction of the heterocycles. Thus, a three-dimensional network structure can be formed. Examples of the organic salt include an iodonium salt, a phosphonium salt, an antimonium salt, a sulfonium salt, and a borate salt. Examples of the heterocycles in the compound having the plurality of heterocycles in a molecule thereof include oxirane, oxetane, oxolane, thiirane, and aziridine.

In the resin material (B2-1) containing the polymer serving as a parent agent and the active energy ray-reactive compound, the content ratio of the active energy ray-reactive compound is preferably from 0.1 part by weight to 500 parts by weight, more preferably from 1 part by weight to 300 parts by weight, still more preferably from 10 parts by weight to 200 parts by weight with respect to 100 parts by weight of the polymer serving as a parent agent.

An example of the active energy ray-reactive polymer is a polymer having an active energy ray-reactive functional group having a carbon-carbon multiple bond, such as an acryloyl group, a methacryloyl group, a vinyl group, an allyl group, or an acetylene group. A compound (polymer) having an ethylenically unsaturated functional group is preferably used, and a (meth)acrylic polymer having an acryloyl group or a methacryloyl group is more preferably used. A specific example of the polymer having an active energy ray-reactive functional group is a polymer formed from a polyfunctional (meth)acrylate. The polymer formed from a polyfunctional (meth)acrylate has in a side chain thereof preferably an alkyl ester having 4 or more carbon atoms, more preferably an alkyl ester having 6 or more carbon atoms, still more preferably an alkyl ester having 8 or more carbon atoms, particularly preferably an alkyl ester having 8 to 20 carbon atoms, most preferably an alkyl ester having 8 to 18 carbon atoms.

The resin material (B2-2) containing the active energy ray-reactive polymer may further contain the active energy ray-reactive compound (monomer or oligomer).

The active energy ray-curable pressure-sensitive adhesive can be cured through irradiation with an active energy ray. The pressure-sensitive adhesive sheet of the present invention can allow an adherend to adhere thereto by bonding the adherend thereto before the curing of the pressure-sensitive adhesive, and then curing the pressure-sensitive adhesive through irradiation with an active energy ray. Examples of the active energy ray include a gamma ray, UV light, visible light, an infrared ray (heat ray), a radio wave, an alpha ray, a beta ray, an electron beam, a plasma flow, an ionizing ray, and a particle beam. The conditions, such as wavelength and irradiation dose, of the active energy ray may be set to any appropriate conditions depending on, for example, the kind of the resin material to be used. For example, the pressure-sensitive adhesive may be cured through irradiation with UV light at an irradiation dose of from 10 mJ/cm$^2$ to 1,000 mJ/cm$^2$.

C-2. Intermediate Layer

Examples of the form of the intermediate layer include a resin layer and a layer having a pressure-sensitive adhesive property.

In one embodiment, the intermediate layer contains a thermoplastic resin. Such intermediate layer may be, for example, a resin film containing a thermoplastic resin, or a layer containing a pressure-sensitive adhesive C formed of a thermoplastic resin. In another embodiment, the intermediate layer contains a curable resin (e.g., a UV-curable resin or a thermosetting resin). Such intermediate layer may be, for example, a resin film containing a curable resin, or a layer containing a curable pressure-sensitive adhesive D.

The thickness of the intermediate layer is preferably from 0.1 $\mu$m to 200 $\mu$m, more preferably from 0.5 $\mu$m to 100 $\mu$m, still more preferably from 1 $\mu$m to 50 $\mu$m, particularly preferably from 1 $\mu$m to 30 $\mu$m. When the thickness falls within such ranges, an intermediate layer that satisfactorily functions as a gas barrier layer can be formed.

The water vapor transmission rate of the intermediate layer is preferably 5,000 g/(m$^2$·day) or less, more preferably 4,800 g/(m$^2$·day) or less, still more preferably 4,500 g/(m$^2$·day) or less, still more preferably 4,200 g/(m$^2$·day) or less. When the water vapor transmission rate falls within such ranges, the intermediate layer satisfactorily functions as a gas barrier layer, and hence a deformed portion of an excellent shape is formed. When such pressure-sensitive adhesive sheet is used, a small adherend (e.g., electronic part) can be accurately peeled. The water vapor transmission rate of the intermediate layer is preferably as small as possible, but its lower limit value is, for example, 0.1 g/(m$^2$·day).

The piercing strength of the intermediate layer is preferably from 300 mN to 5,000 mN, more preferably from 500 mN to 4,500 mN, still more preferably from 1,000 mN to 4,000 mN. When the piercing strength falls within such ranges, the intermediate layer satisfactorily functions as a gas barrier layer, and besides, a change in shape due to gas generation occurs in a preferred manner, with the result that a protrusion of an excellent shape is formed. When such pressure-sensitive adhesive sheet is used, a small adherend (e.g., electronic part) can be accurately peeled.

The UV light transmittance of the intermediate layer at a wavelength of 360 nm is preferably from 50% to 100%, more preferably from 60% to 95%.

C-2-1. Intermediate Layer as Resin Layer

The intermediate layer as the resin layer is formed from, for example, a resin film. Examples of a resin for forming the resin film include a polyethylene terephthalate-based resin, a polyolefin-based resin, a styrene-based elastomer (e.g., SEBS), a UV-curable resin, a thermosetting resin, a urethane-based resin, and an epoxy-based resin. In one embodiment, the resin film is formed from a thermoplastic resin.

The thickness of the resin film is preferably from 0.1 $\mu$m to 50 $\mu$m, more preferably from 0.5 $\mu$m to 30 $\mu$m, still more preferably from 1 $\mu$m to 20 $\mu$m.

C-2-2. Intermediate Layer as Layer having Pressure-sensitive Adhesive Property

Examples of the intermediate layer as a layer having a pressure-sensitive adhesive property include an intermediate layer containing a pressure-sensitive adhesive having pressure sensitivity, and an intermediate layer containing a curable pressure-sensitive adhesive. An intermediate layer containing a curable pressure-sensitive adhesive C is preferably arranged. Particularly when, as the pressure-sensitive adhesive layer, a pressure-sensitive adhesive layer containing the pressure-sensitive adhesive A having pressure sensitivity and an intermediate layer containing the curable pressure-sensitive adhesive C are combined, a pressure-sensitive adhesive sheet capable of forming a more satisfactory deformed portion through laser light irradiation can be obtained. The pressure-sensitive adhesive described in the section C-1-2 may be used as the curable pressure-sensitive adhesive C.

The thickness of the intermediate layer as a layer having a pressure-sensitive adhesive property is preferably from 5 $\mu$m to 50 $\mu$m, more preferably from 5 $\mu$m to 30 $\mu$m.

D. Method of producing Pressure-sensitive Adhesive Sheet

The pressure-sensitive adhesive sheet of the present invention may be produced by any appropriate method. An example of the method of producing the pressure-sensitive adhesive sheet of the present invention is a method involving directly applying a composition for forming a gas-generating layer containing the pressure-sensitive adhesive A and the UV absorber onto a predetermined base material to form the gas-generating layer, and applying a composition for forming a pressure-sensitive adhesive layer containing the pressure-sensitive adhesive B onto the gas-generating layer to form the pressure-sensitive adhesive layer. In one embodiment, when the pressure-sensitive adhesive sheet includes the intermediate layer, the composition for forming an intermediate layer is applied onto the gas-generating layer to form the intermediate layer before the formation of the pressure-sensitive adhesive layer, and the composition for forming a pressure-sensitive adhesive layer is applied onto the intermediate layer to form the pressure-sensitive adhesive layer. In addition, the layers may be separately formed and then bonded to each other to form the pressure-sensitive adhesive sheet.

Any appropriate application method may be adopted as an application method for each of the above-mentioned compositions. For example, each layer may be formed by application, followed by drying. Examples of the application method include application methods each using a multicoater, a die coater, a gravure coater, an applicator, or the like. As a drying method, there are given, for example, natural drying and drying by heating. When the drying by heating is performed, a heating temperature may be set to any appropriate temperature depending on the characteristics of a substance to be dried. In addition, active energy ray irradiation (e.g., UV irradiation) may be performed depending on the form of each layer.

E. Method of processing Electronic Part

A method of treating an electronic part of the present invention includes: bonding an electronic part onto the pressure-sensitive adhesive sheet; and peeling the electronic part from the pressure-sensitive adhesive sheet by irradiating the pressure-sensitive adhesive sheet with laser light. Examples of the electronic part include a semiconductor chip, a LED chip, and a MLCC.

The peeling of the electronic part is performed in a position-selective manner. Specifically, it may be appropriate that a plurality of electronic parts be bonded and fixed to the pressure-sensitive adhesive sheet, and the peeling of the electronic parts be performed so that some of the electronic parts may be peeled and the other electronic part(s) may remain fixed.

In one embodiment, the method of treating an electronic part of the present invention further includes subjecting the electronic part to a predetermined treatment after the bonding of the electronic part onto the pressure-sensitive adhesive sheet and before the peeling of the electronic part from the pressure-sensitive adhesive sheet. The treatment is not particularly limited, and examples thereof include treatments, such as grinding processing, dicing processing, die bonding, wire bonding, etching, vapor deposition, molding, circuit formation, inspection, a product check, cleaning, transfer, arrangement, repair, or protection of a device surface.

The size of the electronic part (area of the bonding surface thereof) is, for example, from 1 $\mu m^2$ to 250,000 $\mu m^2$. In one embodiment, such an electronic part that the size of the electronic part (area of the bonding surface thereof) is from 1 $\mu m^2$ to 6,400 $\mu m^2$ may be subjected to the treatment. In another embodiment, such an electronic part that the size of the electronic part (area of the bonding surface thereof) is from 1 $\mu m^2$ to 2,500 $\mu m^2$ may be subjected to the treatment.

In one embodiment, as described above, a plurality of electronic parts may be arranged on the pressure-sensitive adhesive sheet. An interval between the electronic parts is, for example, from 1 $\mu m$ to 500 $\mu m$. In the present invention, there is an advantage in that the bodies to be treated can be temporarily fixed at a small interval.

For example, UV laser light may be used as the laser light. The irradiation output of the laser light is, for example, from 1 $\mu J$ to 1,000 $\mu J$. The wavelength of the UV laser light is, for example, from 240 nm to 380 nm.

In one embodiment, the method of treating an electronic part includes placing the electronic part on another sheet (e.g., a pressure-sensitive adhesive sheet or a substrate) after the peeling of the electronic part.

Examples

Now, the present invention is specifically described by way of Examples. However, the present invention is by no means limited to these Examples. Evaluation methods in Examples are as described below. In the following evaluations, a pressure-sensitive adhesive sheet from which a separator had been peeled was used. In addition, in Examples, "part(s)" and "%" are by weight unless otherwise stated.

(1) Modulus of Elasticity

The modulus of elasticity of each of a sectional surface of a gas barrier layer and a sectional surface of a gas-generating layer (each of Examples 10 and 11) was measured with a nanoindenter (Triboindenter TI-950 manufactured by Hysitron, Inc.) by a single indentation method at a predetermined temperature (25°C) under the measurement conditions of an indentation speed of about 500 nm/sec, a drawing speed of about 500 nm/sec, and an indentation depth of about 1,500 nm.

(2) Piercing Strength

As illustrated in FIG. 3, the piercing strength was measured by sandwiching a sample 4 between sample holders **5A** and **5B** having a circular opening with a diameter of 11.28 mm through use of a compression testing machine 6 (manufactured by Kato Tech Co., Ltd., product name: "KES-G5"). More specifically, a piercing needle (radius of curvature: 1 mm) was caused to pierce the sample (piercing speed: 0.1 mm/s) at the center of the circular opening under a measurement temperature of 23°C, and the maximum load at the breaking point was defined as the piercing strength.

(3) Elongation in Normal Direction

In the measurement of (2) descried above, the distance by which the piercing needle was pushed at the breaking point was measured, and the elongation of the sample in its plane direction was defined as its elongation in a normal direction.

(4) Change in Surface Shape

A glass plate (manufactured by Matsunami Glass Ind., Ltd., Large Slide Glass S9112 (standard, large-sized, WHITE EDGE GRINDING No. 2)) was bonded to the gas-generating layer side of a pressure-sensitive adhesive sheet (opposite side thereof to its pressure-sensitive adhesive layer) to provide a measurement sample. The measurement sample was subjected to a pulse scan from its glass plate side with UV laser light having a wavelength of 355 nm and a beam diameter of about 20 $\mu m\varphi$ at an output of 0.80 mW and a frequency of 40 kHz to generate a gas from the gas-generating layer. A pressure-sensitive adhesive layer surface corresponding to any appropriate one spot subjected to the pulse scan was observed with a confocal laser microscope after 24 hours from the laser light irradiation, and a vertical displacement Y and a horizontal displacement X (diameter; full width at half maximum) were measured.

When the displacement Y is 8 $\mu m$ or more, peelability is remarkably excellent ("◎" in the tables); when the displacement Y is 0.6 μm or more and less than 8 μm, peelability is satisfactory ("∘" in the tables); and when the displacement Y is less than 0.6 μm, peelability is insufficient ("×" in the tables) .

(5) Pressure-Sensitive Adhesive Strength (Gas-generating Layer Side)

PET#25 was bonded to the pressure-sensitive adhesive layer side of a pressure-sensitive adhesive sheet to provide a measurement sample. The pressure-sensitive adhesive strength of the gas-generating layer side of the measurement sample with respect to SUS430 was measured by a method in conformity with JIS Z 0237:2000 (bonding conditions: one pass back and forth with a 2 kg roller, tensile rate: 300 mm/min, peel angle: 180°).

(6) Pressure-Sensitive Adhesive Strength (Pressure-Sensitive Adhesive Layer)

PET#25 was bonded to the gas-generating layer side of a pressure-sensitive adhesive sheet to provide a measurement sample. The pressure-sensitive adhesive strength of the pressure-sensitive adhesive layer side of the measurement sample with respect to SUS430 was measured by a method in conformity with JIS Z 0237:2000 (bonding conditions: one pass back and forth with a 2 kg roller, tensile rate: 300 mm/min, peel angle: 180°).

[Production Example 1] Preparation of Pressure-sensitive Adhesive "a"

30 Parts by weight of 2-ethylhexyl acrylate, 70 parts by weight of ethyl acrylate, 4 parts by weight of 2-hydroxyethyl acrylate, 5 parts by weight of methyl methacrylate, and 0.2 part by weight of benzoyl peroxide serving as a polymerization initiator were added into toluene, and then the mixture was heated to 70°C to provide a toluene solution of an acrylic copolymer (polymer A).
The toluene solution of the polymer A (polymer A: 100 parts by weight), 3 parts by weight of an isocyanate-based cross-linking agent (manufactured by Nippon Polyurethane Industry Co., Ltd., product name: "Coronate L"), and 5 parts by weight of a surfactant (manufactured by Kao Corporation, product name: "EXCEPARL IPP") were mixed to prepare a pressure-sensitive adhesive "a". The composition of the pressure-sensitive adhesive "a" is shown in Table 1.

[Production Example 2] Preparation of Pressure-sensitive Adhesive "b"

100 Parts by weight of a maleic acid-modified styrene-ethylene-butylene-styrene block copolymer (SEBS: styrene moiety/ethylene-butylene moiety (weight ratio)=30/70, acid value: 10 (mg-$CH_3ONa$/g), manufactured by Asahi Kasei Chemicals Corporation, product name: "Tuftec M1913"), 3 parts by weight of an epoxy-based cross-linking agent (manufactured by Mitsubishi Gas Chemical Company, Inc., product name: "TETRAD-C"), 3 parts by weight of a fatty acid ester-based surfactant (manufactured by Kao Corporation, product name: "EXCEPARL IPP", molecular weight: 298.5, carbon number of alkyl group: 16), and toluene serving as a solvent were mixed to provide a pressure-sensitive adhesive "b". The composition of the pressure-sensitive adhesive "b" is shown in Table 1.

[Production Example 3] Preparation of Pressure-sensitive Adhesive "c"

95 Parts by weight of 2-ethylhexyl acrylate, 5 parts by weight of acrylic acid, and 0.15 part by weight of benzoyl peroxide serving as a polymerization initiator were added into ethyl acetate, and then the mixture was heated to 70°C to provide an ethyl acetate solution of an acrylic copolymer (polymer A2).
The ethyl acetate solution of the polymer A2 (polymer A2: 100 parts by weight), 1 part by weight of an epoxy-based cross-linking agent (manufactured by Mitsubishi Gas Chemical Company, Inc., product name: "TETRAD-C"), and 3 parts by weight of an isocyanate-based cross-linking agent (manufactured by Nippon Polyurethane Industry Co., Ltd., product name: "Coronate L") were mixed to prepare a pressure-sensitive adhesive "c". The composition of the pressure-sensitive adhesive "c" is shown in Table 1.

Table 1

| Pressure-sensitive adhesive composition | | Production Example 1 Pressure-sensitive adhesive "a" | Production Example 2 Pressure-sensitive adhesive "b" | Production Example 3 Pressure-sensitive adhesive "c" |
|---|---|---|---|---|
| Base polymer | Material | Acrylic | SEBS-based | Acrylic |
| | Kind of polymer | Polymer A | | Polymer A2 |

(continued)

| Pressure-sensitive adhesive composition | | Production Example 1 Pressure-sensitive adhesive "a" | Production Example 2 Pressure-sensitive adhesive "b" | Production Example 3 Pressure-sensitive adhesive "c" |
|---|---|---|---|---|
| Cross-linking agent | Kind of cross-linking agent | Isocyanate-based | Epoxy-based | Isocyanate-based |
| | Product name/ number of parts | Coronate/L (3) | TETRAD-C (3) | Coronate/L (3) |
| | Kind of cross-linking agent | - | - | Epoxy-based |
| | Product name/ number of parts | - | - | TETRAD-C (1) |
| Surfactant | Kind of surfactant | Fatty acid ester-based | Fatty acid ester-based | - |
| | Product name/ number of parts | EXCEPARL IPP (5) | EXCEPARL IPP (3) | - |
| | | Example 1 and Examples 3 to 9 Comparative Examples 2 and 5 to 8 | Example 2 Comparative Examples 3 and 4 | Reference Examples 1 and 2 |

[Production Example 4] Preparation of Composition "a" for forming Intermediate Layer

30 Parts by weight of 2-ethylhexyl acrylate, 70 parts by weight of methyl acrylate, 10 parts by weight of acrylic acid, and 0.2 part by weight of benzoyl peroxide serving as a polymerization initiator were added into ethyl acetate, and then the mixture was heated to 70°C to provide an ethyl acetate solution of an acrylic copolymer (polymer B).

The ethyl acetate solution of the polymer B (polymer B: 100 parts by weight), 1 part by weight of an epoxy-based cross-linking agent (manufactured by Mitsubishi Gas Chemical Company, Inc., product name: "TETRAD-C"), 50 parts by weight of a UV oligomer (manufactured by Mitsubishi Chemical Corporation, product name: "SHIKOH UV-1700B"), and 3 parts by weight of a photopolymerization initiator (manufactured by BASF SE, product name: "Omnirad 127") were mixed to prepare a composition "a" for forming an intermediate layer. The composition of the composition "a" for forming an intermediate layer is shown in Table 2.

[Production Example 5] Preparation of Composition "b" for forming Intermediate Layer

100 Parts by weight of a maleic acid-modified styrene-ethylene-butylene-styrene block copolymer (SEBS: styrene moiety/ethylene-butylene moiety (weight ratio)=30/70, acid value: 10 (mg-$CH_3ONa$/g), manufactured by Asahi Kasei Chemicals Corporation, product name: "Tuftec M1913"), 3 parts by weight of an epoxy-based cross-linking agent (manufactured by Mitsubishi Gas Chemical Company, Inc., product name: "TETRAD-C"), 3 parts by weight of a fatty acid ester-based surfactant (manufactured by Kao Corporation, product name: "EXCEPARL IPP", molecular weight: 298.5, carbon number of alkyl group: 16), and toluene serving as a solvent were mixed to provide a composition "b" for forming an intermediate layer. The composition of the composition "b" for forming an intermediate layer is shown in Table 2.

Table 2

| Composition for forming intermediate layer | | Production Example 4 Composition "a" for forming intermediate layer | Production Example 5 Composition "b" for forming intermediate layer |
|---|---|---|---|
| Base polymer | Material | Acrylic | SEBS-based |
| | Kind of polymer | Polymer B | |
| UV oligomer | UV oligomer | UV-curable urethane acrylate | - |
| | Product name/number of parts | UV-1700B (50) | - |

(continued)

| Composition for forming intermediate layer | | Production Example 4 Composition "a" for forming intermediate layer | Production Example 5 Composition "b" for forming intermediate layer |
|---|---|---|---|
| Cross-linking agent | Kind of cross-linking agent | Epoxy-based | Epoxy-based |
| | **Product name/ number** of parts | TETRAD-C (1.0) | TETRAD-C (3) |
| Photopolymerization initiator | Photopolymerization initiator | Alkylphenone-based | - |
| | Product name/number of parts | Irg127 (3) | - |
| | | Examples 3 and 4 Comparative Example 5 | Examples 5 and 6 Comparative Examples 6 and 7 |

[Production Example 6] Preparation of Composition "a" for forming Gas-generating Layer
The polymer A was obtained in the same manner as in Production Example 1.
The toluene solution of the polymer A (polymer A: 100 parts by weight), 1.5 parts by weight of an isocyanate-based cross-linking agent (manufactured by Nippon Polyurethane Industry Co., Ltd., product name: "Coronate L"), and 20 parts by weight of a UV absorber (manufactured by BASF SE, product name: "Tinuvin 477") were mixed to prepare a composition "a" for forming a gas-generating layer. The composition of the composition "a" for forming a gas-generating layer is shown in Table 3.

[Production Example 7] Preparation of Composition "b" for forming Gas-generating Layer

95 Parts by weight of 2-ethylhexyl acrylate, 5 parts by weight of acrylic acid, and 0.15 part by weight of benzoyl peroxide serving as a polymerization initiator were added into ethyl acetate, and then the mixture was heated to 70°C to provide an ethyl acetate solution of an acrylic copolymer (polymer C).
The ethyl acetate solution of the polymer C (polymer C: 100 parts by weight), 0.1 part by weight of an epoxy-based cross-linking agent (manufactured by Mitsubishi Gas Chemical Company, Inc., product name: "TETRAD-C"), and 20 parts by weight of a UV absorber (manufactured by BASF SE, product name: "Tinuvin 477") were mixed to prepare a composition "b" for forming a gas-generating layer. The composition of the composition "b" for forming a gas-generating layer is shown in Table 3.

[Production Example 8] Preparation of Composition "c" for forming Gas-generating Layer

100 Parts by weight of a maleic acid-modified styrene-ethylene-butylene-styrene block copolymer (SEBS: styrene moiety/ethylene-butylene moiety (weight ratio)=30/70, acid value: 10 (mg-$CH_3ONa/g$), manufactured by Asahi Kasei Chemicals Corporation, product name: "Tuftec M1913"), 3 parts by weight of an epoxy-based cross-linking agent (manufactured by Mitsubishi Gas Chemical Company, Inc., product name: "TETRAD-C"), 20 parts by weight of a UV absorber (manufactured by BASF SE, product name: "Tinuvin 477"), and toluene serving as a solvent were mixed to provide a composition "c" for forming a gas-generating layer. The composition of the composition "c" for forming a gas-generating layer is shown in Table 3.

[Example 1]

The pressure-sensitive adhesive "a" obtained in Production Example 1 was applied to a polyethylene terephthalate film with a silicone release agent-treated surface (thickness: 75 μm) so as to have a thickness of 50 μm after solvent volatilization (drying), and was then dried to form a pressure-sensitive adhesive layer precursor layer "a" on the polyethylene terephthalate film.
The composition "a" for forming a gas-generating layer obtained in Production Example 5 was applied to a polyethylene terephthalate film with a silicone release agent-treated surface (manufactured by Toray Industries, Inc., product name: "Cerapeel", thickness: 38 μm) so as to have a thickness of 15 μm after solvent volatilization (drying), and was then dried to form a gas-generating layer precursor layer "a" on the polyethylene terephthalate film.

The pressure-sensitive adhesive layer precursor layer "a" and the gas-generating layer precursor layer "a" were bonded to each other through lamination between rolls to provide a pressure-sensitive adhesive sheet (pressure-sensitive adhesive layer/gas-generating layer) sandwiched between the polyethylene terephthalate films with silicone release agent-treated surfaces.

The resultant pressure-sensitive adhesive sheet was subjected to the evaluations (1) to (6). The results are shown in Table 3.

[Example 2]

A pressure-sensitive adhesive sheet was obtained in the same manner as in Example 1 except that: the pressure-sensitive adhesive "b" was used in place of the pressure-sensitive adhesive "a"; and the thickness of the pressure-sensitive adhesive layer was changed to 30 $\mu$m. The resultant pressure-sensitive adhesive sheet was subjected to the evaluations (1) to (6). The results are shown in Table 3.

[Example 3]

The pressure-sensitive adhesive "a" obtained in Production Example 1 was applied to a polyethylene terephthalate film with a silicone release agent-treated surface (thickness: 75 $\mu$m) so as to have a thickness of 7 $\mu$m after solvent volatilization (drying), and was then dried to form a pressure-sensitive adhesive layer precursor layer "a" on the polyethylene terephthalate film.

The composition "a" for forming an intermediate layer obtained in Production Example 3 was applied to a polyethylene terephthalate film with a silicone release agent-treated surface (manufactured by Toray Industries, Inc., product name: "Cerapeel", thickness: 38 $\mu$m) so as to have a thickness of 15 $\mu$m after solvent volatilization (drying), and was then dried to form an intermediate layer precursor layer "a" on the polyethylene terephthalate film.

Next, the pressure-sensitive adhesive layer precursor layer "a" and the intermediate layer precursor layer "a" were bonded to each other through lamination between rolls, and the resultant was subjected to UV irradiation from the intermediate layer precursor layer side under the condition of 500 mJ/cm$^2$ to provide a gas barrier layer precursor layer "a" sandwiched between the polyethylene terephthalate films with silicone release agent-treated surfaces.

The composition "a" for forming a gas-generating layer obtained in Production Example 5 was applied to a polyethylene terephthalate film with a silicone release agent-treated surface (manufactured by Toray Industries, Inc., product name: "Cerapeel", thickness: 38 $\mu$m) so as to have a thickness of 7 $\mu$m after solvent volatilization (drying), and was then dried to form a gas-generating layer precursor layer "a" on the polyethylene terephthalate film.

The polyethylene terephthalate film with a silicone release agent-treated surface on the intermediate layer precursor layer "a" side of the gas barrier layer precursor layer "a" was peeled, and then the intermediate layer precursor layer "a" of the laminate precursor layer "a" and the gas-generating layer precursor layer "a" were bonded to each other through lamination between rolls to provide a pressure-sensitive adhesive sheet (pressure-sensitive adhesive layer/intermediate layer/gas-generating layer) sandwiched between the polyethylene terephthalate films with silicone release agent-treated surfaces.

The resultant pressure-sensitive adhesive sheet was subjected to the evaluations (1) to (6). The results are shown in Table 3.

[Example 4]

A pressure-sensitive adhesive sheet was obtained in the same manner as in Example 3 except that the thickness of the intermediate layer was changed to 7 $\mu$m. The resultant pressure-sensitive adhesive sheet was subjected to the evaluations (1) to (6). The results are shown in Table 3.

[Example 5]

A pressure-sensitive adhesive sheet was obtained in the same manner as in Example 3 except that: the composition "b" for forming an intermediate layer was used in place of the composition "a" for forming an intermediate layer; and the thickness of the intermediate layer was changed to 30 $\mu$m. The resultant pressure-sensitive adhesive sheet was subjected to the evaluations (1) to (6). The results are shown in Table 3.

[Example 6]

A pressure-sensitive adhesive sheet was obtained in the same manner as in Example 3 except that the thickness of the intermediate layer was changed to 15 $\mu$m. The resultant pressure-sensitive adhesive sheet was subjected to the evaluations (1) to (6). The results are shown in Table 3.

[Example 7]

The pressure-sensitive adhesive "a" obtained in Production Example 1 was applied to a polyethylene terephthalate film with a silicone release agent-treated surface (thickness: 75 $\mu$m) so as to have a thickness of 7 $\mu$m after solvent volatilization (drying), and was then dried to form a pressure-sensitive adhesive layer precursor layer "a" on the polyethylene terephthalate film.

The composition "a" for forming a gas-generating layer obtained in Production Example 5 was applied to a polyethylene terephthalate film with a silicone release agent-treated surface (manufactured by Toray Industries, Inc., product name: "Cerapeel", thickness: 38 $\mu$m) so as to have a thickness of 7 $\mu$m after solvent volatilization (drying), and was then dried to form a gas-generating layer precursor layer "a" on the polyethylene terephthalate film.

The pressure-sensitive adhesive layer precursor layer "a" was bonded to one side of a polyethylene terephthalate film (manufactured by Toray Industries, Inc., product name: "Lumirror #2F51N", thickness: 2 $\mu$m) through lamination between rolls.

Next, the gas-generating layer precursor layer "a" was bonded to the opposite side of the polyethylene terephthalate film to the pressure-sensitive adhesive layer precursor layer "a" through lamination between rolls.

Thus, a pressure-sensitive adhesive sheet (pressure-sensitive adhesive layer/intermediate layer/gas-generating layer) sandwiched between the polyethylene terephthalate films with silicone release agent-treated surfaces was obtained.

The resultant pressure-sensitive adhesive sheet was subjected to the evaluations (1) to (6). The results are shown in Table 3.

[Example 8]

A pressure-sensitive adhesive sheet was obtained in the same manner as in Example 7 except that a PET film having a thickness of 4.5 $\mu$m was used. The resultant pressure-sensitive adhesive sheet was subjected to the evaluations (1) to (6). The results are shown in Table 3.

[Example 9]

A pressure-sensitive adhesive sheet was obtained in the same manner as in Example 7 except that a PET film having a thickness of 9 $\mu$m was used. The resultant pressure-sensitive adhesive sheet was subjected to the evaluations (1) to (6). The results are shown in Table 3.

[Example 10]

The composition "b" for forming a gas-generating layer was applied to one surface of a polyethylene terephthalate film (manufactured by Toray Industries, Inc., product name: "Lumirror S10", thickness: 50 $\mu$m) so as to have a thickness of 20 $\mu$m after solvent volatilization (drying), to thereby form a gas-generating layer.

Next, the pressure-sensitive adhesive "c" was applied to a polyethylene terephthalate film with a silicone release agent-treated surface (manufactured by Toray Industries, Inc., product name: "Cerapeel", thickness: 38 $\mu$m) so as to have a thickness of 10 $\mu$m after solvent volatilization (drying), to thereby form a pressure-sensitive adhesive layer.

Next, the gas-generating layer and the pressure-sensitive adhesive layer were laminated to provide a pressure-sensitive adhesive sheet (pressure-sensitive adhesive layer/gas-generating layer/base material) protected by the polyethylene terephthalate film with a silicone release agent-treated surface.

The resultant pressure-sensitive adhesive sheet was subjected to the evaluations. The results are shown in Table 4.

[Example 11]

A pressure-sensitive adhesive sheet was obtained in the same manner as in Example 10 except that the composition "c" for forming a gas-generating layer was used in place of the composition "b" for forming a gas-generating layer. The resultant pressure-sensitive adhesive sheet was subjected to the evaluations. The results are shown in Table 4.

[Comparative Example 1]

The composition "a" for forming a gas-generating layer obtained in Production Example 5 was applied to a polyethylene terephthalate film with a silicone release agent-treated surface (manufactured by Toray Industries, Inc., product name: "Cerapeel", thickness: 38 $\mu$m) so as to have a thickness of 7 $\mu$m after solvent volatilization (drying), and was then dried to form a pressure-sensitive adhesive sheet formed only of a gas-generating layer on the polyethylene terephthalate film. The resultant pressure-sensitive adhesive sheet was subjected to the evaluations (1) to (6). The results are shown in Table 5.

[Comparative Example 2]

A pressure-sensitive adhesive sheet was obtained in the same manner as in Example 1 except that the thickness of the pressure-sensitive adhesive layer was changed to 7 $\mu$m. The resultant pressure-sensitive adhesive sheet was subjected to the evaluations (1) to (6). The results are shown in Table 5.

[Comparative Example 3]

A pressure-sensitive adhesive sheet was obtained in the same manner as in Example 2 except that the thickness of the pressure-sensitive adhesive layer was changed to 2 $\mu$m. The resultant pressure-sensitive adhesive sheet was subjected to the evaluations (1) to (6). The results are shown in Table 5.

[Comparative Example 4]

A pressure-sensitive adhesive sheet was obtained in the same manner as in Example 2 except that the thickness of the pressure-sensitive adhesive layer was changed to 60 $\mu$m. The resultant pressure-sensitive adhesive sheet was subjected to the evaluations (1) to (6). The results are shown in Table 5.

[Comparative Example 5]

A pressure-sensitive adhesive sheet was obtained in the same manner as in Example 3 except that the thickness of the intermediate layer was changed to 40 $\mu$m. The resultant pressure-sensitive adhesive sheet was subjected to the evaluations (1) to (6). The results are shown in Table 5.

[Comparative Example 6]

A pressure-sensitive adhesive sheet was obtained in the same manner as in Example 5 except that the thickness of the intermediate layer was changed to 2 $\mu$m. The resultant pressure-sensitive adhesive sheet was subjected to the evaluations (1) to (6). The results are shown in Table 5.

[Comparative Example 7]

A pressure-sensitive adhesive sheet was obtained in the same manner as in Example 5 except that the thickness of the intermediate layer was changed to 60 $\mu$m. The resultant pressure-sensitive adhesive sheet was subjected to the evaluations (1) to (6). The results are shown in Table 5.

[Comparative Example 8]

A pressure-sensitive adhesive sheet was obtained in the same manner as in Example 7 except that a PET film having a thickness of 25 $\mu$m was used. The resultant pressure-sensitive adhesive sheet was subjected to the evaluations (1) to (6). The results are shown in Table 5.

Table 3

| | | | Example 1 | Example 2 | Example 3 | Example 4 | Example 5 |
|---|---|---|---|---|---|---|---|
| Gas barrier layer | Pressure-sensitive adhesive layer | Pressure-sensitive adhesive | Pressure-sensitive adhesive "a" | Pressure-sensitive adhesive "b" | Pressure-sensitive adhesive "a" | Pressure-sensitive adhesive "a" | Pressure-sensitive adhesive "a" |
| | | Thickness [μm] | 50 | 30 | 7 | 7 | 7 |
| | | Modulus of elasticity of pressure-sensitive adhesive layer [MPa] | 2.45 | 78 | 2.45 | 2.45 | 2.45 |
| | | Piercing strength of pressure-sensitive adhesive layer [mN] | 282.1 | 928.8 | 112.5 | 112.5 | 112.5 |
| | | Elongation of pressure-sensitive adhesive layer in normal direction [mm] | 18.4 | 5.38 | 7.94 | 7.94 | 7.94 |
| | Intermediate layer | Material for intermediate layer | - | - | Composition "a" for forming intermediate layer | Composition "a" for forming intermediate layer | Composition "b" for forming intermediate layer |
| | | Thickness [μm] | - | - | 15 | 7 | 30 |
| | | Modulus of elasticity of intermediate layer [MPa] | - | - | 1,778 | 1,778 | 78 |
| | | Piercing strength of intermediate layer [mN] | - | - | 1,344.1 | 1,380.0 | 928.8 |
| | | Piercing strength of intermediate layer per unit thickness [mN/μm] | | | 89.6 | 197.1 | 31.0 |
| | | Elongation of intermediate layer in normal direction [mm] | - | - | 2.18 | 2.42 | 5.38 |
| | | $3501 \times EXP(-0.812 \times \log_{10}(Er \times 10^6))$ | 195.34 | 57.79 | 19.15 | 19.15 | 57.79 |
| | | $2008 \times EXP(-1.145 \times \log_{10}(Er \times 10^6))$ | 13.34 | 2.40 | 0.50 | 0.50 | 2.40 |
| Gas-generating layer | Material for gas-generating layer | Material | Acrylic | Acrylic | Acrylic | Acrylic | Acrylic |
| | | Kind of polymer | Polymer A | Polymer A | Polymer A | Polymer A | Polymer A |
| | | Kind of cross-linking agent | Isocyanate-based | Isocyanate-based | Isocyanate-based | Isocyanate-based | Isocyanate-based |
| | | Number of parts of cross-linking agent | Coronate/L (1.5) | Coronate/L (1.5) | Coronate/L (1.5) | Coronate/L (1.5) | Coronate/L (1.5) |
| | | Kind (skeleton) of UV absorber | Hydroxyphenyltriazine-based | Hydroxyphenyltriazine-based | Hydroxyphenyltriazine-based | Hydroxyphenyltriazine-based | Hydroxyphenyltriazine-based |
| | | Product name/number of parts | Tinuvin 477 (20) | Tinuvin 477 (20) | Tinuvin 477 (20) | Tinuvin 477 (20) | Tinuvin 477 (20) |
| | | Thickness [μm] | 15 | 15 | 7 | 7 | 7 |
| Pressure-sensitive adhesive sheet | | Thickness [μm] | 65 | 45 | 29 | 21 | 44 |
| | Gas barrier characteristics | Piercing strength [N] | 219.7 | 926.4 | 1,393.0 | 1,364.5 | 538.6 |
| | | Elongation in normal direction [mm] | 14.77 | 5.58 | 1.98 | 1.78 | 5.76 |
| | Change in surface shape | Height (Y: vertical displacement) | 2.4 | 1.6 | 1.9 | 1.4 | 2.1 |
| | | Diameter (X: horizontal displacement) | 4.5 | 6.5 | 11.1 | 13.2 | 8.6 |
| | | State | Foaming (protrusion) | Foaming (protrusion) | Foaming (protrusion) | Foaming (protrusion) | Foaming (protrusion) |
| | | Pressure-sensitive adhesive strength with respect to SUS430 [N/20 mm] (pressure-sensitive adhesive layer side) | 4.60 | 0.50 | 0.63 | 0.93 | 1.38 |
| | | Pressure-sensitive adhesive strength with respect to SUS430 [N/20 mm] (gas-generating layer side) | 6.53 | 5.32 | 2.14 | 2.67 | 3.37 |
| | | Peelability | ○ | ○ | ◎ | ◎ | ◎ |

| | | | Example 6 | Example 7 | Example 8 | Example 9 |
|---|---|---|---|---|---|---|
| Gas barrier layer | Pressure-sensitive adhesive layer | Pressure-sensitive adhesive | Pressure-sensitive adhesive "a" | Pressure-sensitive adhesive "a" | Pressure-sensitive adhesive "a" | Pressure-sensitive adhesive "a" |
| | | Thickness [μm] | 7 | 7 | 7 | 7 |
| | | Modulus of elasticity of pressure-sensitive adhesive layer [MPa] | 2.45 | 2.45 | 2.45 | 2.45 |
| | | Piercing strength of pressure-sensitive adhesive layer [mN] | 112.5 | 112.5 | 112.5 | 112.5 |
| | | Elongation of pressure-sensitive adhesive layer in normal direction [mm] | 7.94 | 7.94 | 7.94 | 7.94 |
| | Intermediate | Material for intermediate | Composition | PET | PET | PET |

| | | | | "b" for forming intermediate layer | | | |
|---|---|---|---|---|---|---|---|
| iate layer | layer | | | | | | |
| | Thickness [μm] | | | 15 | 2 | 4.5 | 9 |
| | Modulus of elasticity of intermediate layer [MPa] | | | 78 | 3,450 | 3,450 | 3,450 |
| | Piercing strength of intermediate layer [mN] | | | 512.2 | 1,271.1 | 1,192.1 | 1,237.6 |
| | Piercing strength of intermediate layer per unit thickness [mN/μm] | | | 34.1 | 635.6 | 264.9 | 137.5 |
| | Elongation of intermediate layer in normal direction [mm] | | | 5.88 | 2.26 | 1.48 | 1.03 |
| | $35011 \times EXP(-0.812 \times \log_{10}(Er \times 10^6))$ | | | 57.79 | 15.16 | 15.16 | 15.16 |
| | $20081 \times EXP(-1.145 \times \log_{10}(Er \times 10^6))$ | | | 2.40 | 0.36 | 0.36 | 0.36 |
| Gas-generating layer | Material for gas-generating layer | Material | | Acrylic | Acrylic | Acrylic | Acrylic |
| | | Kind of polymer | | Polymer A | Polymer A | Polymer A | Polymer A |
| | | Kind of cross-linking agent | | Isocyanate-based | Isocyanate-based | Isocyanate-based | Isocyanate-based |
| | | Number of parts of cross-linking agent | | Coronate/L (1.5) | Coronate/L (1.5) | Coronate/L (1.5) | Coronate/L (1.5) |
| | | Kind (skeleton) of UV absorber | | Hydroxyphenyltriazine-based | Hydroxyphenyltriazine-based | Hydroxyphenyltriazine-based | Hydroxyphenyltriazine-based |
| | | Product name/number of parts | | Tinuvin 477 (20) | Tinuvin 477 (20) | Tinuvin 477 (20) | Tinuvin 477 (20) |
| | Thickness [μm] | | | 7 | 7 | 7 | 7 |
| Pressure-sensitive adhesive sheet | Thickness [μm] | | | 29 | 16 | 18.5 | 23 |
| | Gas barrier characteristics | Piercing strength [N] | | 512.2 | 1,113.1 | 1,242.3 | 1,316.6 |
| | | Elongation in normal direction [mm] | | 5.55 | 2.29 | 1.42 | 1.09 |
| | Change in surface shape | Height (Y: vertical displacement) | | 1.2 | 10.6 | 3.4 | 2.5 |
| | | Diameter (X: horizontal displacement) | | 10.1 | 51.2 | 40.4 | 30.0 |
| | | State | | Foaming (protrusion) | Foaming (protrusion) | Foaming (protrusion) | Foaming (protrusion) |

| | | | | | |
|---|---|---|---|---|---|
| | Pressure-sensitive adhesive strength with respect to SUS430 [N/20 mm] (pressure-sensitive adhesive layer side) | 2.73 | 0.33 | 0.41 | 0.38 |
| | Pressure-sensitive adhesive strength with respect to SUS430 [N/20 mm] (gas-generating layer side) | 4.37 | 4.74 | 4.54 | 4.78 |
| | Peelability | ◎ | ◎ | ○ | ○ |

Table 4

| | | | Example 10 | Example 11 |
|---|---|---|---|---|
| Gas barrier layer | Pressure-sensitive adhesive layer | Pressure-sensitive adhesive | Pressure-sensitive adhesive "c" | Pressure-sensitive adhesive "c" |
| | | Thickness [$\mu$m] | 10 | 10 |
| | | Modulus of elasticity of pressure-sensitive adhesive layer [MPa] | 7.76 | 7.76 |
| | | Piercing strength of pressure-sensitive adhesive layer [mN] | 134.0 | 134.0 |
| | | Elongation of pressure-sensitive adhesive layer in normal direction [mm] | 9.32 | 9.32 |
| | Intermediate layer | Material for intermediate layer | - | - |
| | | Thickness [$\mu$m] | - | - |
| | | Modulus of elasticity of intermediate layer [MPa] | - | - |
| | | Piercing strength of intermediate layer [mN] | - | - |
| | | Piercing strength of intermediate layer per unit thickness [mN/m] | | |
| | | Elongation of intermediate layer in normal direction [mm] | - | - |
| | | $35011 \times EXP(-0.812 \times \log_{10}(Er \times 10^6)$ | 130.16 | 130.16 |
| | | $20081 \times EXP(-1.145 \times \log_{10}(Er \times 10^6)$ | 7.53 | 7.53 |

(continued)

| | | | Example 10 | Example 11 |
|---|---|---|---|---|
| Gas-generating layer | Material for gas-generating layer | Material | Acrylic | Rubber-based |
| | | Kind of polymer | Polymer C | SEBS |
| | | Kind of cross-linking agent | Epoxy-based | Epoxy-based |
| | | Number of parts of cross-linking agent | TETRAD-C (0.1) | TETRAD-C (3) |
| | | Kind (skeleton) of UV absorber | Hydroxyphenyltriazine-based | Hydroxyphenyltriazine-based |
| | | Product name/ number of parts | Tinuvin 477 (20) | Tinuvin 477 (20) |
| | Thickness [$\mu$m] | | 20 | 20 |
| | Modulus of elasticity Er(gas) [MPa] | | 0.95 | 77.62 |
| | Log Er(gas) | | 5.98 | 7.89 |
| | $8.01 \times h(gas)^{-0.116}$ | | 5.66 | 5.66 |
| | Lower limit value of modulus of elasticity of gas-generating layer calculated from $Log(Er(gas) \times 10^6) \geq 8.01 \times h(gas)^{-0.116}$ [MPa] | | 0.46 | 0.46 |
| | $7.66 \times h(gas)^{-0.092}$ | | 5.81 | 5.81 |
| | Lower limit value of modulus of elasticity of gas-generating layer calculated from $Log(Er(gas) \times 10^6) \geq 7.66 \times h(gas)^{-0.092}$ [MPa] | | 0.65 | 0.65 |
| | $7.52 \times h(gas)^{-0.081}$ | | 5.90 | 5.90 |
| | Lower limit value of modulus of elasticity of gas-generating layer calculated from $Log(Er(gas) \times 10^6) \geq 7.52 \times h(gas)^{-0.081}$ [MPa] | | 0.79 | 0.79 |
| | $47.675 \times h(gas)^{-0.519}$ | | 10.07 | 10.07 |
| | Upper limit value of modulus of elasticity of gas-generating layer calculated from $Log(Er(gas) \times 10^6) \leq 47.675 \times h(gas)^{-0.519}$ [MPa] | | 11,765.71 | 11,765.71 |
| Base material | Material for base material | | PET | PET |
| | Thickness [$\mu$m] | | 50 | 50 |
| Pressure-sensitive adhesive sheet | Thickness [$\mu$m] | | 80 | 80 |
| | Change in surface shape | | Foaming (protrusion) | Foaming (protrusion) |
| | Pressure-sensitive adhesive strength with respect to SUS430 [N/20 mm] (pressure-sensitive adhesive layer side) | | 0.69 | 0.25 |
| | Peelability | | ○ | ○ |

Table 5

| | | | | Comparative Example 1 | Comparative Example 2 | Comparative Example 3 | Comparative Example 4 |
|---|---|---|---|---|---|---|---|
| Gas barrier layer | Pressure-sensitive adhesive layer | Pressure-sensitive adhesive | | - | Pressure-sensitive adhesive "a" | Pressure-sensitive adhesive "b" | Pressure-sensitive adhesive "b" |
| | | Thickness [μm] | | - | 7 | 2 | 60 |
| | | Modulus of elasticity of pressure-sensitive adhesive layer [MPa] | | - | 2.45 | 78 | 78 |
| | | Piercing strength of pressure-sensitive adhesive layer [mN] | | - | 112.5 | 211.7 | 1,512.0 |
| | | Elongation of pressure-sensitive adhesive layer in normal direction [mm] | | - | 7.9 | 6.07 | 4.87 |
| | Intermediate layer | Material for intermediate layer | | - | - | - | - |
| | | Thickness [μm] | | - | - | - | - |
| | | Modulus of elasticity of intermediate layer [MPa] | | - | - | - | - |
| | | Piercing strength of intermediate layer [mN] | | - | - | - | - |
| | | Piercing strength of intermediate layer per unit thickness [mN/μm] | | - | - | - | - |
| | | Elongation of intermediate layer in normal direction [mm] | | - | - | - | - |
| | 35011×EXP(-0.812×log₁₀(Er×10⁶)) | | | - | 195.34 | 57.79 | 57.79 |
| | 20081×EXP(-1.145×log₁₀(Er×10⁶)) | | | - | 13.34 | 2.40 | 2.40 |
| Gas-generating layer | Material for gas-generating layer | Material | | Acrylic | Acrylic | Acrylic | Acrylic |
| | | Kind of polymer | | Polymer A | Polymer A | Polymer A | Polymer A |
| | | Kind of cross-linking agent | | Isocyanate-based | Isocyanate-based | Isocyanate-based | Isocyanate-based |
| | | Number of parts of cross-linking agent | | Coronate/L (1.5) | Coronate/L (1.5) | Coronate/L (1.5) | Coronate/L (1.5) |
| | | Kind (skeleton) of UV absorber | | Hydroxyphenyltriazine-based | Hydroxyphenyltriazine-based | Hydroxyphenyltriazine-based | Hydroxyphenyltriazine-based |
| | | Product name/number of parts | | Tinuvin 477 (20) | Tinuvin 477 (20) | Tinuvin 477 (20) | Tinuvin 477 (20) |
| | Thickness [μm] | | | 7 | 15 | 15 | 15 |
| Pressure-sensitive adhesive sheet | Thickness [μm] | | | 7 | 35 | 22 | 65 |
| | Gas barrier characteristics | Piercing strength [N] | | 112.5 | 192.8 | 808.9 | 1,011.0 |
| | | Elongation in normal direction [mm] | | 7.95 | 12.57 | 4.58 | 6.14 |
| | Change in surface shape | Height (Y: vertical displacement) | | -6.7 | -21.2 | -15.9 | 0.3 |
| | | Diameter (X: horizontal displacement) | | 19.1 | 21.9 | 15.4 | 18.0 |
| | | State | | Rupture (depression) | Rupture (depression) | Rupture (depression) | Flat (-) |
| | Pressure-sensitive adhesive strength with respect to SUS430 [N/20 mm] (pressure-sensitive adhesive layer side) | | | 5.45 | 5.60 | 0.40 | 0.25 |
| | Pressure-sensitive adhesive strength with respect to SUS430 [N/20 mm] (gas-generating layer side) | | | 6.02 | 7.02 | 4.71 | 4.30 |
| | Peelability | | | Δ | Δ | Δ | × |

| | | | Comparative Example 5 | Comparative Example 6 | Comparative Example 7 | Comparative Example 8 |
|---|---|---|---|---|---|---|
| | Pressure-sensitive adhesive layer | Pressure-sensitive adhesive | Pressure-sensitive adhesive "a" | Pressure-sensitive adhesive "a" | Pressure-sensitive adhesive "a" | Pressure-sensitive adhesive "a" |
| | | Thickness [μm] | 7 | 7 | 7 | 7 |
| | | Modulus of elasticity of pressure-sensitive adhesive layer [MPa] | 2.45 | 2.45 | 2.45 | 2.45 |
| | | Piercing strength of pressure-sensitive adhesive layer [mN] | 112.5 | 112.5 | 112.5 | 112.5 |
| | | Elongation of pressure-sensitive adhesive layer in | 7.94 | 7.94 | 7.94 | 7.94 |

| | | | Composition "a" for forming intermediate layer | Composition "b" for forming intermediate layer | Composition "b" for forming intermediate layer | PET |
|---|---|---|---|---|---|---|
| | normal direction [mm] | | | | | |
| Intermediate layer | Material for intermediate layer | | Composition "a" for forming intermediate layer | Composition "b" for forming intermediate layer | Composition "b" for forming intermediate layer | PET |
| | Thickness [μm] | | 40 | 2 | 60 | 25 |
| | Modulus of elasticity of intermediate layer [MPa] | | 1,778 | 78 | 78 | 3,450 |
| | Piercing strength of intermediate layer [mN] | | 1,320.0 | 60.5 | 1,512.0 | 1,287.8 |
| | Piercing strength of intermediate layer per unit thickness [mN/μm] | | 33.0 | 30.3 | 25.2 | 51.5 |
| | Elongation of intermediate layer in normal direction [mm] | | 2.18 | 6.07 | 4.87 | 0.88 |
| $35011 \times EXP(-0.812 \times \log_{10}(Er \times 10^6))$ | | | 19.15 | 57.79 | 57.79 | 15.16 |
| $20081 \times EXP(-1.145 \times \log_{10}(Er \times 10^6))$ | | | 0.50 | 2.40 | 2.40 | 0.36 |
| Gas-generating layer | Material for gas-generating layer | Material | Acrylic | Acrylic | Acrylic | Acrylic |
| | | Kind of polymer | Polymer A | Polymer A | Polymer A | Polymer A |
| | | Kind of cross-linking agent | Isocyanate-based | Isocyanate-based | Isocyanate-based | Isocyanate-based |
| | | Number of parts of cross-linking agent | Coronate/L (1.5) | Coronate/L (1.5) | Coronate/L (1.5) | Coronate/L (1.5) |
| | | Kind (skeleton) of UV absorber | Hydroxyphenyltriazine-based | Hydroxyphenyltriazine-based | Hydroxyphenyltriazine-based | Hydroxyphenyltriazine-based |
| | | Product name/number of parts | Tinuvin 477 (20) | Tinuvin 477 (20) | Tinuvin 477 (20) | Tinuvin 477 (20) |
| | Thickness [μm] | | 7 | 7 | 7 | 7 |
| Pressure-sensitive adhesive sheet | Thickness [μm] | | 54 | 21 | 64 | 26 |
| | Gas barrier characteristics | Piercing strength [N] | 1,323.7 | 868.9 | 1,111.0 | 1,220.8 |
| | | Elongation in normal direction [mm] | 1.82 | 4.89 | 5.89 | 0.89 |
| | Change in surface shape | Height (Y: vertical displacement) | 0.5 | -14.3 | 0.2 | 0.2 |
| | | Diameter (X: horizontal displacement) | 13.2 | 16.3 | 14.5 | 19.1 |
| | | State | Flat (-) | Rupture (depression) | Flat (-) | Flat (-) |
| | Pressure-sensitive adhesive strength with respect to SUS430 [N/20 mm] (pressure-sensitive adhesive layer side) | | 0.43 | 2.32 | 1.14 | 0.33 |
| | Pressure-sensitive adhesive strength with respect to SUS430 [N/20 mm] (gas-generating layer side) | | 1.78 | 4.80 | 4.10 | 4.22 |
| | Peelability | | × | △ | × | × |

Reference Signs List

10        gas-generating layer
20        gas barrier layer
21        pressure-sensitive adhesive layer
22        intermediate layer
100, 200    pressure-sensitive adhesive sheet

**Claims**

**1.** A pressure-sensitive adhesive sheet, comprising:

a gas-generating layer; and
a gas barrier layer arranged on at least one side of the gas-generating layer,
wherein the gas barrier layer is a layer having a surface that is deformed through laser light irradiation of the pressure-sensitive adhesive sheet,

wherein a thickness ($\mu$m) of a highly elastic portion of the gas barrier layer is equal to or smaller than a value calculated by the following expression (1), and
wherein the thickness ($\mu$m) of the highly elastic portion of the gas barrier layer is equal to or larger than a value calculated by the following expression (2):

$$35011 \times EXP(-0.812 \times \log_{10}(Er \times 10^6)) \quad \cdots \quad (1)$$

$$20081 \times EXP(-1.145 \times \log_{10}(Er \times 10^6)) \quad \cdots \quad (2)$$

where Er represents a modulus of elasticity (MPa) of the highly elastic portion of the gas barrier layer by a nanoindentation method at 25°C.

2. The pressure-sensitive adhesive sheet according to claim 1, wherein the gas-generating layer is a layer capable of absorbing UV light.

3. The pressure-sensitive adhesive sheet according to claim 2, wherein the gas-generating layer contains a UV absorber.

4. The pressure-sensitive adhesive sheet according to any one of claims 1 to 3, wherein the gas barrier layer includes a pressure-sensitive adhesive layer.

5. The pressure-sensitive adhesive sheet according to claim 4, wherein the gas barrier layer further includes an intermediate layer.

6. The pressure-sensitive adhesive sheet according to any one of claims 1 to 5, wherein the modulus of elasticity of the highly elastic portion of the gas barrier layer by the nanoindentation method is from 0.01 MPa to 10 GPa.

7. The pressure-sensitive adhesive sheet according to any one of claims 1 to 6, wherein the gas barrier layer has a thickness of from 0.1 $\mu$m to 200 $\mu$m.

8. A deformation amount of the surface of the gas barrier layer caused by laser light irradiation of the gas barrier layer is 0.6 $\mu$m or more in terms of vertical displacement of the gas barrier layer.

9. The pressure-sensitive adhesive sheet according to any one of claims 1 to 8, wherein the pressure-sensitive adhesive sheet has a piercing strength of from 10 mN to 5,000 mN.

10. The pressure-sensitive adhesive sheet according to any one of claims 1 to 9, wherein an elongation of the pressure-sensitive adhesive sheet in a normal direction is 0.1 mm or more.

11. The pressure-sensitive adhesive sheet according to any one of claims 5 to 10, wherein the intermediate layer contains a thermoplastic resin.

12. The pressure-sensitive adhesive sheet according to any one of claims 5 to 11, wherein the intermediate layer is a resin film formed from a styrene-based elastomer.

13. The pressure-sensitive adhesive sheet according to any one of claims 5 to 10, wherein the intermediate layer contains a curable resin.

14. The pressure-sensitive adhesive sheet according to claim 13, wherein the curable resin is a UV-curable resin.

15. A method of treating an electronic part, comprising:

bonding an electronic part onto the pressure-sensitive adhesive sheet of any one of claims 1 to 14; and
peeling the electronic part from the pressure-sensitive adhesive sheet by irradiating the pressure-sensitive adhesive sheet with laser light.

**16.** The method of treating an electronic part according to claim 15, wherein the peeling the electronic part is performed in a position-selective manner.

**17.** The method of treating an electronic part according to claim 15 or 16, further comprising subjecting the electronic part to a predetermined treatment after the bonding the electronic part onto the pressure-sensitive adhesive sheet and before the peeling the electronic part from the pressure-sensitive adhesive sheet.

**18.** The method of treating an electronic part according to claim 17, wherein the treatment is grinding processing, dicing processing, die bonding, wire bonding, etching, vapor deposition, molding, circuit formation, inspection, a product check, cleaning, transfer, arrangement, repair, or protection of a device surface.

**19.** The method of treating an electronic part according to any one of claims 15 to 18, further comprising placing the electronic part on another sheet after the peeling the electronic part from the pressure-sensitive adhesive sheet.

Fig.1

100

20,21

10

Fig.2

200

21
22
}20

10

Fig.3

6

4

5A

5B

11. 28 mm

| | **INTERNATIONAL SEARCH REPORT** | International application No. |
|---|---|---|
| | | PCT/JP2020/044513 |

A.  CLASSIFICATION OF SUBJECT MATTER
Int.Cl. B32B27/00(2006.01)i, B32B27/18(2006.01)i, B32B27/30(2006.01)i,
C09J5/00(2006.01)i, C09J201/00(2006.01)i, H01L21/301(2006.01)i,
C09J7/29(2018.01)i, C09J7/38(2018.01)i
FI: C09J7/29, C09J7/38, C09J201/00, C09J5/00, B32B27/18A, B32B27/00M,
B32B27/30B, H01L21/78M
According to International Patent Classification (IPC) or to both national classification and IPC

B.  FIELDS SEARCHED

Minimum documentation searched (classification system followed by classification symbols)
Int.Cl. B32B27/00, B32B27/18, B32B27/30, C09J5/00, C09J201/00,
H01L21/301, C09J7/29, C09J7/38

Documentation searched other than minimum documentation to the extent that such documents are included in the fields searched
Published examined utility model applications of Japan    1922–1996
Published unexamined utility model applications of Japan  1971–2021
Registered utility model specifications of Japan          1996–2021
Published registered utility model applications of Japan  1994–2021

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2003-342540 A (ASAHI KASEI CORPORATION) 03 December 2003 (2003-12-03), claims, examples | 1-19 |
| A | JP 2010-202833 A (SEKISUI CHEMICAL CO., LTD.) 16 September 2010 (2010-09-16), claims, examples | 1-19 |
| A | JP 2019-70104 A (SEKISUI CHEMICAL CO., LTD.) 09 May 2019 (2019-05-09), claims, examples | 1-19 |
| A | JP 2010-129699 A (NITTO DENKO CORPORATION) 10 June 2010 (2010-06-10), claims, examples | 1-19 |
| A | JP 2018-141086 A (NITTO DENKO CORPORATION) 13 September 2018 (2018-09-13), claims, examples | 1-19 |
| A | JP 2018-182276 A (NITTO DENKO CORPORATION) 15 November 2018 (2018-11-15), claims, examples | 1-19 |

☐ Further documents are listed in the continuation of Box C.   ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05 January 2021 | 19 January 2021 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**
Information on patent family members

International application No.

PCT/JP2020/044513

| | | |
|---|---|---|
| JP 2003-342540 A | 03 December 2003 | (Family: none) |
| JP 2010-202833 A | 16 September 2010 | (Family: none) |
| JP 2019-70104 A | 09 May 2019 | (Family: none) |
| JP 2010-129699 A | 10 June 2010 | US 2010/0129988 A1<br>claims, examples |
| JP 2018-141086 A | 13 September 2018 | CN 108504298 A<br>KR 10-2018-0099506 A |
| JP 2018-182276 A | 15 November 2018 | JP 2018-182275 A<br>JP 2018-182294 A<br>CN 108727999 A<br>KR 10-2018-0116756 A<br>CN 108735651 A<br>CN 108728000 A<br>KR 10-2018-0116750 A<br>KR 10-2018-0116751 A |

Form PCT/ISA/210 (patent family annex) (January 2015)

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001131507 A
- JP 2003292916 A
- JP 4151850 B